# EUROPEAN PATENT SPECIFICATION

(11) **EP 3 124 563 B1**
(45) Date of publication and mention of the grant of the patent: **23.01.2019**
(21) Application number: 15767949.9
(22) Date of filing: 24.03.2015
(51) Int. Cl.: C09D 161/00, C08K 3/24, C08L 61/20, C08L 79/00, C09D 5/22, C09D 7/65, C09K 11/06, H01B 1/06, H01L 51/50, H05B 33/10, C09D 127/12

(54) **CHARGE-TRANSPORTING VARNISH**
LADUNGSTRANSPORTLACK
VERNIS DE TRANSPORT DE CHARGE

(30) Priority: 27.03.2014 JP 2014065278; 10.07.2014 JP 2014141988
(43) Date of publication of application: 01.02.2017
(73) Proprietor: Nissan Chemical Corporation, Tokyo (JP)
(72) Inventor: OTANI Naoki, Funabashi-shi Chiba 274-0052 (JP); OTA Hirofumi, Funabashi-shi Chiba 274-0052 (JP)
(74) Representative: Mewburn Ellis LLP
(86) International application number: PCT/JP2015/058849
(87) International publication number: WO 2015/146957

(56) References cited:
- WO-A1-2010/058777
- WO-A1-2014/132917
- JP-A- H07 126 615
- JP-A- 2002 025 779
- JP-A- 2002 075 644
- JP-A- 2007 208 102
- JP-A- 2008 016 827
- JP-A- 2010 225 950

## Description

### TECHNICAL FIELD

The present invention relates to charge-transporting varnishes.

### BACKGROUND ART

In organic electroluminescent (hereinafter referred to as organic EL) elements, a charge-transporting thin film is used.

Methods for forming the charge-transporting thin film are generally classified into dry process typified by the vapor deposition method and wet process represented by the spin coating method. These methods are appropriately used selectively, according to the area of the thin film to be formed and the solubility of the substance to be formed into the thin film in organic solvents.

In general, a layer called a hole injection layer and a layer called a hole transport layer are disposed between an anode and a light-emitting layer of an organic EL element, in this order from the anode side. The provision of these two layers makes it possible to enable efficient charge transfer, and to obtain an organic EL element which has high luminance characteristics (see, for example, Non-Patent Document 1).

On the other hand, however, in the organic EL element production process, normally, there is a drawback that independent steps for forming each of these layers are needed.

In the field of electronic devices in recent years, simplification of process and simplification of element structure have been demanded, for the purpose of producing the elements in high yield and efficiently.

Particularly, when a functional multilayer film in which a plurality of layers in an element are formed in a multilayer form is replaced by a single film, not only the production process can be simplified but also the element structure can be directly simplified. In view of this, in the field of various electronic devices, there is a demand for a material from which a functional single film capable of substituting an existing functional multilayer film can be produced.

Thus, in the field of organic EL, also, there has been an increasing demand for a material which enables conversion of a functional multilayer film, composed of a hole injection layer and a hole transport layer as in a general structure, into a single film.

### PRIOR ART DOCUMENT

WO,A,2014 132917, pursuant to Article 54(3) EPC, discloses charge-transporting varnish, but not the N,N,N',N'-tetraarylbenzidine.

JP,A,2002 025779 discloses an organic electroluminescent element.

JP,A,2007 208102 discloses an organic electroluminescent device.

JP,A 2008 016827 discloses an organic electroluminescent element.

JP,A, H07 126615 discloses an electroluminescence device obtained using a tetraphenylbenzidine.

### NON-PATENT DOCUMENT

Non-Patent Document 1: Adachi C. et al., Jpn. J. Appl. Phys., vol. 27(2), 1988, pp. L269-271

### SUMMARY OF THE INVENTION

### PROBLEMS TO BE SOLVED BY THE INVENTION

The present invention has been made in consideration of the above-mentioned circumstances. It is an object of the present invention to provide a charge-transporting varnish which gives a thin film capable of realizing an organic EL element having excellent luminance characteristics, even in the case where the thin film is used as a single layer between, and in contact with, an anode and a light-emitting layer.

### MEANS FOR SOLVING THE PROBLEMS

In order to achieve the above object, the present inventors made extensive and intensive investigations. As a result of their investigations, the inventors have found out that a thin film obtained from a charge-transporting varnish which contains a predetermined fluorine-containing charge-transporting substance, a predetermined non-fluorine-containing substance, and a dopant substance composed of a heteropoly-acid gives an organic EL element having excellent luminance characteristics, even in the case where the thin film is used as a single layer between, and in contact with, an anode and a light-emitting layer. On the basis of the finding, the inventors have completed the present invention.

Specifically, the present invention provides:
1. A charge-transporting varnish including: a fluorine-containing charge-transporting substance; a non-fluorine-containing charge-transporting substance; a dopant substance composed of a heteropoly-acid; and an organic solvent,
   wherein the fluorine-containing charge-transporting substance is a polymer which has a weight average molecular weight measured by gel permeation chromatography of 500 to 200,000 and which is obtainable by condensing: at least one compound selected from triarylamine compounds and N,N,N',N'-tetraarylbenzidine compounds; an N,N,N',N'-tetraarylbenzidine compound having at least one aryl group substituted with an alkoxy group which may include an ether linkage; a fluorine-containing aryl aldehyde compound; and a fluorene derivative having a carbonyl group, and
   the non-fluorine-containing charge-transporting substance is an oligoaniline compound.
2. The charge-transporting varnish according to 1 above, wherein the fluorine-containing charge-transporting substance is a polymer obtained by condensing: at least one compound selected from triarylamine compounds represented by formula
   (1) and N,N,N',N'-tetraarylbenzidine compounds represented by formula (2); an N,N,N',N'-tetraarylbenzidine compound represented by formula (3); a fluorine-containing aryl aldehyde compound represented by formula (4); and a fluorene derivative having a carbonyl group that is represented by formula (5) or formula (6): 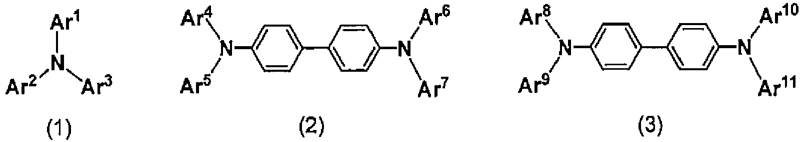 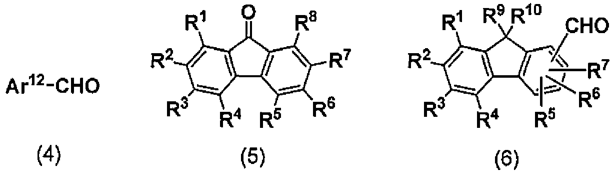
   wherein Ar¹ to Ar⁷ each independently represent an aryl group which has 6 to 20 carbon atoms and may be substituted with Z¹, provided that at least one of ring-forming carbon atoms in each of Ar¹ to Ar³ is unsubstituted, and at least one of ring-forming carbon atoms in each of Ar⁴ to Ar⁷ is unsubstituted,
   Ar⁸ to Ar¹¹ each independently represent an aryl group which has 6 to 20 carbon atoms and may be substituted with Z², provided that at least one of ring-forming carbon atoms in at least two of Ar⁸ to Ar¹¹ is unsubstituted, and at least one of Ar⁸ to Ar¹¹ is substituted with Z²,
   Ar¹² represents an aryl group which has 6 to 20 carbon atoms and is substituted with at least one Z³ and which may be substituted with Z⁴,
   R¹ to R⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
   R⁹ and R¹⁰ each independently represent a hydrogen atom, an alkyl group having 1 to 20 carbon atoms, (poly)ethylene oxide group having 2 to 20 carbon atoms, alkenyl group having 2 to 20 carbon atoms or alkynyl group having 2 to 20 carbon atoms which may be substituted with Z⁵, or an alkyl group which has 1 to 20 carbon atoms and is substituted with an ethenyl group or an ethynyl group and which may be substituted with Z⁵,
   Z¹ represents a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
   Z² represents an alkoxy group which has 1 to 20 carbon atoms and may include an ether linkage,
   Z³ represents a fluorine atom, a fluorinated alkyl group having 1 to 20 carbon atoms, or a fluorinated aryl group having 6 to 20 carbon atoms,
   Z⁴ represents a chlorine atom, a bromine atom, an iodine atom, a nitro group, a cyano group, or an alkyl group having 1 to 20 carbon atoms, alkenyl group having 2 to 20 carbon atoms or alkynyl group having 2 to 20 carbon atoms which may be substituted with Z⁶,
   Z⁵ represents a halogen atom, a nitro group, or a cyano group, and
   Z⁶ represents a chlorine atom, a bromine atom, an iodine atom, a nitro group, or a cyano group.
3. The charge-transporting varnish according to 2 above, wherein the triarylamine compound is a triphenylamine derivative represented by formula (7): 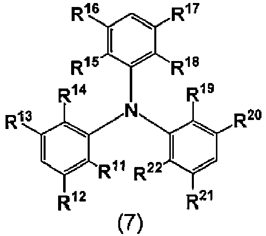 wherein R¹¹ to R²² each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵, and Z⁵ has the same meaning as mentioned in statement 2 above.
4. The charge-transporting varnish according to 2 above, wherein the N,N,N',N'-tetraarylbenzidine compound represented by the formula (2) is represented by formula (8): 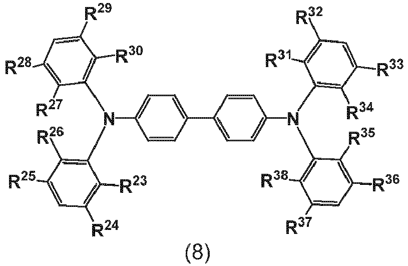 wherein R²³ to R³⁸ each independently represent a hydrogen atom, a halogen atom, a nitro group, a cyano group,
   or an alkyl group having 1 to 20 carbon atoms, alkenyl group having 2 to 20 carbon atoms or alkynyl group having 2 to 20 carbon atoms which may be substituted with Z⁵, and Z⁵ has the same meaning as mentioned in statement 2 above.
5. The charge-transporting varnish according to 2 above, wherein the N,N,N',N'-tetraarylbenzidine compound represented by the formula (3) is represented by formula (9-1): 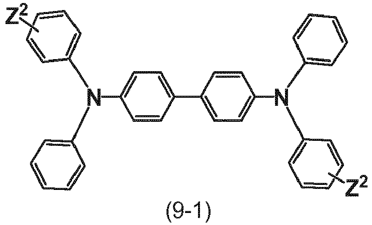 wherein Z² has the same meaning as mentioned in statement 2 above.
6. The charge-transporting varnish according to 5 above, wherein the N,N,N',N'tetraarylbenzidine compound represented by the formula (3) is represented by formula (9-2): 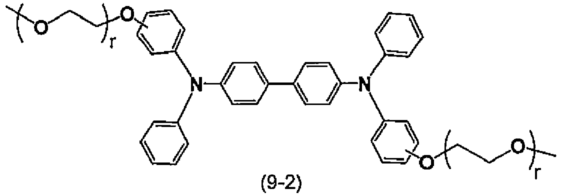 wherein letters r each represent an integer of 1 to 10.
7. The charge-transporting varnish according to 6 above, wherein the N,N,N',N'-tetraarylbenzidine compound represented by the formula (3) is represented by any one of formulas (10-1) to (10-8). 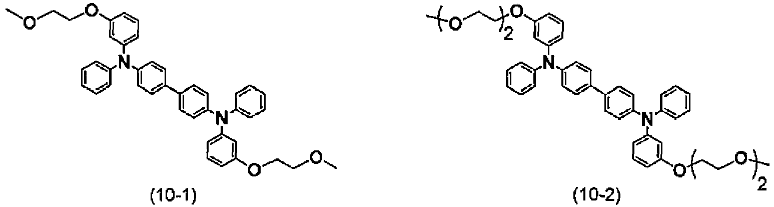 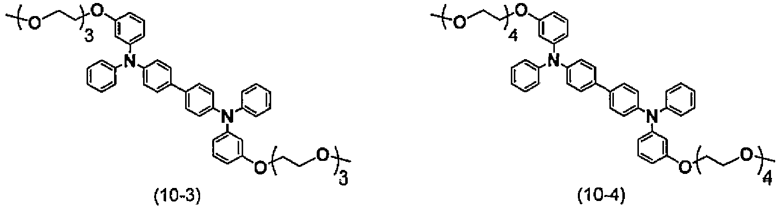 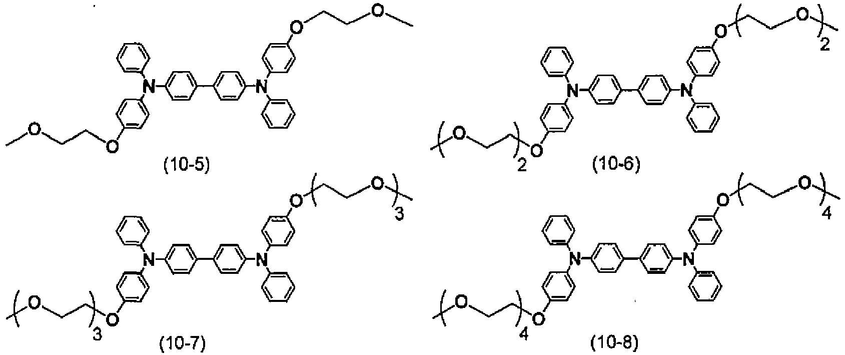
8. The charge-transporting varnish according to 7 above, wherein the N,N,N',N'-tetraarylbenzidine compound represented by the formula (3) is represented by the formula (10-7).
9. The charge-transporting varnish according to any one of 2 to 8 above, wherein the aryl aldehyde compound is represented by formula (11) or formula (12): 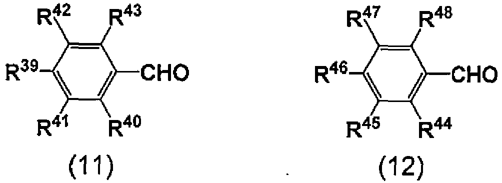
   wherein R³⁹ represents a fluorine atom or a fluorinated alkyl group having 1 to 20 carbon atoms,
   R⁴⁰ to R⁴³ each independently represent a hydrogen atom, a nitro group, a cyano group, or an alkyl group which has 1 to 20 carbon atoms and may be substituted with a nitro group or a cyano group, and
   R⁴⁴ to R⁴⁸ each independently represent a fluorine atom or a fluorinated alkyl group having 1 to 20 carbon atoms.
10. The charge-transporting varnish according to any one of 1 to 9 above, wherein the oligoaniline compound is represented by formula (13); 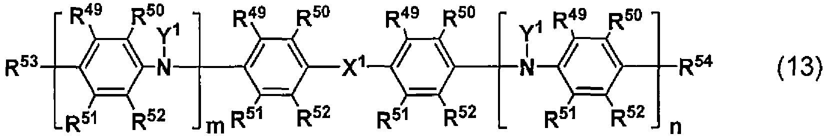
   wherein R⁴⁹ to R⁵⁴ each independently represent a hydrogen atom, a halogen atom (exclusive of a fluorine atom), a nitro group, a cyano group, an alkyl group having 1 to 20 carbon atoms, alkenyl group having 2 to 20 carbon atoms or alkynyl group having 2 to 20 carbon atoms which may be substituted with Z⁷, an aryl group having 6 to 20 carbon atoms or heteroaryl group having 2 to 20 carbon atoms which may be substituted with Z⁸, a -NHY², -NY³Y⁴, -C(O)Y⁵, -OY⁶, -SY⁷, -SO₃Y⁸, -C(O)OY⁹, -OC(O)Y¹⁰, -C(O)NHY¹¹, or -C(O)NY¹²Y¹³ group,
   Y² to Y¹³ each independently represent an alkyl group having 1 to 20 carbon atoms, alkenyl group having 2 to 20 carbon atoms or alkynyl group having 2 to 20 carbon atoms which may be substituted with Z⁷, or an aryl group having 6 to 20 carbon atoms or heteroaryl group having 2 to 20 carbon atoms which may be substituted with Z⁸,
   X¹ represents -NY¹-, -O-, -S-, -(CR⁵⁵R⁵⁶)₁- or a single bond, where R⁵⁵ and R⁵⁶ have the same meaning as the R⁴⁹,
   letter 1 is an integer of 1 to 20,
   Y¹ each independently represents a hydrogen atom, an alkyl group having 1 to 20 carbon atoms, alkenyl group having 2 to 20 carbon atoms or alkynyl group having 2 to 20 carbon atoms which may be substituted with Z⁷, or an aryl group having 6 to 20 carbon atoms or heteroaryl group having 2 to 20 carbon atoms which may be substituted with Z⁸,
   Z⁷ represents a halogen atom (exclusive of a fluorine atom), a nitro group, a cyano group, or an aryl group having 6 to 20 carbon atoms or heteroaryl group having 2 to 20 carbon atoms which may be substituted with Z⁹,
   Z⁸ represents a halogen atom (exclusive of a fluorine atom), a nitro group, a cyano group, or an alkyl group having 1 to 20 carbon atoms, alkenyl group having 2 to 20 carbon atoms or alkynyl group having 2 to 20 carbon atoms which may be substituted with Z⁹,
   Z⁹ represents a halogen atom (exclusive of a fluorine atom), a nitro group or a cyano group, and
   letters m and n are each independently an integer of 1 to 10, satisfying m+n ≤ 10.
11. The charge-transporting varnish according to any one of 1 to 10 above, wherein the heteropoly-acid is phosphotungstic acid.
12. A charge-transporting thin film produced by use of the charge-transporting varnish according to any one of 1 to 11 above.
13. An organic electroluminescent element including the charge-transporting thin film according to 12 above.
14. An organic electroluminescent element including at least an anode, a cathode, a light-emitting layer, and the charge-transporting thin film according to 12 above,
   wherein the charge-transporting thin film is provided between, and in contact with, the anode and the light-emitting layer.
15. A method of producing a charge-transporting thin film, characterized by applying the charge-transporting varnish according to any one of 1 to 11 above onto a substrate, and evaporating the solvent.
16. A method of producing an organic electroluminescent element, wherein the charge-transporting thin film according to 12 above is used.
17. A polymer which has a weight average molecular weight measured by gel permeation chromatography of 500 to 200,000 and which is obtainable by condensing: at least one compound selected from triarylamine compounds represented by formula (1) and N,N,N',N'-tetraarylbenzidine compounds represented by formula (2); an N,N,N',N'-tetraarylbenzidine compound represented by formula (3); a fluorine-containing aryl aldehyde compound represented by formula (4); and a fluorene derivative having a carbonyl group that is represented by formula (5) or formula (6); and 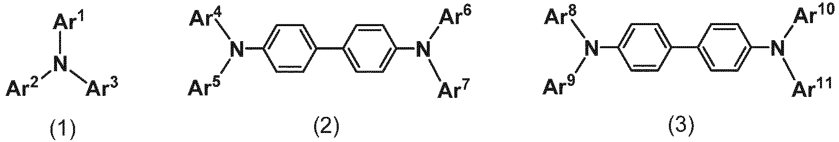 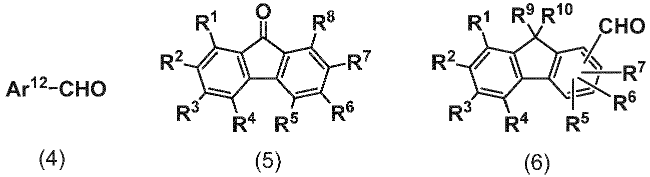
   wherein Ar¹ to Ar⁷ each independently represent an aryl group which has 6 to 20 carbon atoms and may be substituted with Z¹, provided that at least one of ring-forming carbon atoms in each of Ar¹ to Ar³ is unsubstituted, and at least one of ring-forming carbon atoms in each of Ar⁴ to Ar⁷ is unsubstituted,
   Ar⁸ to Ar¹¹ each independently represent an aryl group which has 6 to 20 carbon atoms and may be substituted with Z², provided that at least one of ring-forming carbon atoms in at least two of Ar⁸ to Ar¹¹ is unsubstituted, and at least one of Ar⁸ to Ar¹¹ is substituted with Z²,
   Ar¹² represents an aryl group which has 6 to 20 carbon atoms and is substituted with at least one Z³ and which may be substituted with Z⁴,
   R¹ to R⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
   R⁹ and R¹⁰ each independently represent a hydrogen atom, an alkyl group having 1 to 20 carbon atoms, (poly)ethylene oxide group having 2 to 20 carbon atoms, alkenyl group having 2 to 20 carbon atoms or alkynyl group having 2 to 20 carbon atoms which may be substituted with Z⁵, or an alkyl group which has 1 to 20 carbon atoms and is substituted with an ethenyl group or an ethynyl group and which may be substituted with Z⁵,
   Z¹ represents a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
   Z² represents an alkoxy group which has 1 to 20 carbon atoms and may include an ether linkage,
   Z³ represents a fluorine atom, a fluorinated alkyl group having 1 to 20 carbon atoms, or a fluorinated aryl group having 6 to 20 carbon atoms,
   Z⁴ represents a chlorine atom, a bromine atom, an iodine atom, a nitro group, a cyano group, or an alkyl group having 1 to 20 carbon atoms, alkenyl group having 2 to 20 carbon atoms or alkynyl group having 2 to 20 carbon atoms which may be substituted with Z⁶,
   Z⁵ represents a halogen atom, a nitro group, or a cyano group, and
   Z⁶ represents a chlorine atom, a bromine atom, an iodine atom, a nitro group, or a cyano group.

### ADVANTAGEOUS EFFECTS OF THE INVENTION

The charge-transporting varnishes of the present invention are capable of giving an organic EL element having excellent luminance characteristics, even where a thin film is formed from the charge-transporting varnish as a single layer between, and in contact with, an anode and a light-emitting layer. The reason for this has not been elucidated, but is surmised as follows. The fluorine-containing charge-transporting substance is liable to migrate toward the front surface side (light-emitting layer side) of the thin film. Therefore, the fluorine-containing charge-transporting substance is predominantly present on the front surface side (light-emitting layer side) of the thin film, whereas the non-fluorine-containing charge-transporting substance is predominantly present on the back surface side (anode side) of the thin film. Thus, phase separation into a hole injection portion and a hole transport portion occurs within the single layer. Accordingly, the quantity or concentration of the hole-injecting component decreases, whereas the quantity or concentration of the hole-transporting component increases, along the direction from the anode toward the light-emitting layer. As a result of this, it is conjectured, the single layer functions as a hole injection and transport layer, like in the case where a hole injection layer and a hole transport layer are present.

By use of the charge-transporting varnishes of the present invention, a functional multilayer film in an element can be converted to a single film. Accordingly, it is possible, through simplification of production process conditions, to contrive an enhanced yield and a lowered cost, or to make the element lighter in weight and compacter.

In addition, the charge-transporting varnishes of the present invention enable a thin film excellent in charge-transporting properties to be produced with good reproducibility, even when wet processes capable of forming a film over a large area, such as the spin coating method and the slit coating method, are used. Therefore, the charge-transporting varnishes make it possible to sufficiently cope with the progress in the field of organic EL elements in recent years.

Further, the thin films obtained from the charge-transporting varnishes of the present invention can be used also as anti-static films, anode buffer layers in organic thin film solar cells, and the like.

### EMBODIMENT FOR CARRYING OUT THE INVENTION

The present invention will be described more in detail below.

The charge-transporting varnish according to the present invention contains a fluorine-containing charge-transporting substance, a non-fluorine-containing charge-transporting substance, a dopant substance composed of a heteropoly-acid, and an organic solvent, characterized in that the fluorine-containing charge-transporting substance is a polymer which has a weight average molecular weight of 500 to 200,000 and which is obtained by condensing: at least one compound selected from triarylamine compounds and N,N,N',N'-tetraarylbenzidine compounds; an N,N,N',N'-tetraarylbenzidine compound having at least one aryl group substituted with an alkoxy group which may include an ether linkage; a fluorine-containing aryl aldehyde compound; and a fluorene derivative having a carbonyl group, and that the non-fluorine-containing charge-transporting substance is an oligoaniline compound.

In the present invention, a charge-transporting property is the same in meaning with a conductive property, and with a hole-transporting property. The charge-transporting substance may be a substance which itself has a charge-transporting property, or may be a substance which exhibits a charge-transporting property when used together with a dopant substance. The charge-transporting varnish may be a varnish which itself has a charge-transporting property, or may be a varnish a solid film obtained from which has a charge-transporting property.

In the present invention, the triarylamine compounds used for producing the fluorine-containing charge-transporting substance are not particularly limited, but are preferably compounds represented by the formula (1).

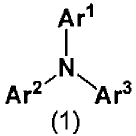

In the formula (1), Ar¹ to Ar³ each independently represent an aryl group which has 6 to 20 carbon atoms and may be substituted with Z¹, provided that at least one of ring-forming carbon atoms in each of Ar¹ to Ar³ is unsubstituted (namely, is accompanied by a hydrogen atom on the carbon atom), since the aryl group having 6 to 20 carbon atoms must have a portion which contributes to a condensation reaction with the aldehyde compound or the fluorene derivative.

Specific examples of the aryl group having 6 to 20 carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, or 9-phenanthryl, among which preferred is a phenyl group which may be substituted with Z¹.

The substituent Z¹ represents a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵, wherein Z⁵ represents a halogen atom, a nitro group, or a cyano group.

Examples of the halogen atom include, fluorine atom, chlorine atom, bromine atom, or iodine atom.

The alkyl group having 1 to 20 carbon atoms may be any of straight-chain, branched-chain and cyclic alkyl groups having 1 to 20 carbon atoms, examples of which include straight-chain or branched-chain alkyl groups having 1 to 20 carbon atoms such as methyl, ethyl, n-propyl, isopropyl, n-butyl, isobutyl, s-butyl, t-butyl, n-pentyl, n-hexyl, n-heptyl, n-octyl, n-nonyl, or n-decyl; and cyclic alkyl groups having 3 to 20 carbon atoms such as cyclopropyl, cyclobutyl, cyclopentyl, cyclohexyl, cycloheptyl, cyclooctyl, cyclononyl, cyclodecyl, bicyclobutyl, bicyclopentyl, bicyclohexyl, bicycloheptyl, bicyclooctyl, bicyclononyl, or bicyclodecyl.

Specific examples of the alkenyl group having 2 to 20 carbon atoms include ethenyl, n-1-propenyl, n-2-propenyl, 1-methylethenyl, n-1-butenyl, n-2-butenyl, n-3-butenyl, 2-methyl, 1-propenyl, 2-methyl-2-proponyl, 1-ethylethenyl, 1-methyl-1-propenyl, 1-methyl-2-propenyl, n-1-pentenyl, n-1-decenyl, or n-1-eicosenyl.

Specific examples of the alkynyl group having 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl, or n-1-eicosynyl.

Among these, preferred as the substituent Z¹ are a halogen atom, a nitro group, a cyano group, and an alkyl group which has 1 to 20 carbon atoms and may be substituted with Z⁵, more preferred is the halogen atom and an alkyl group which has 1 to 4 carbon atoms and may be substituted with Z⁵, and the most suitable is the absence (namely, that the Ar¹ to Ar³ are each an unsubstituted aryl group).

Besides, as the substituent Z⁵, preferred is a halogen atom, more preferred is a fluorine atom, and the most suitable is the absence (namely, non-substitution with Z⁵).

Specific examples of the triarylamine compounds include, triphenylamine derivatives represented by formula (7).

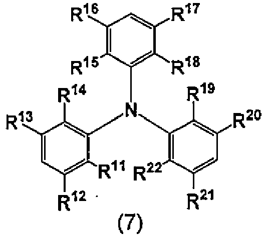

In the formula (7), R¹¹ to R²² each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵. Here, examples of the halogen atom, the alkyl group, the alkenyl group, and the alkynyl group include the same atoms and groups as above-mentioned.

Preferred as R¹¹ to R²² are the hydrogen atom, the halogen atoms, the nitro group, the cyano group, and the alkyl groups which have 1 to 20 carbon atoms and may be substituted with Z⁵, more preferred are the hydrogen atom, a fluorine atom, and an alkyl groups which have 1 to 4 carbon atoms and may be substituted with Z⁵, and the most suitable is that all the R¹¹ to R²² are hydrogen atoms.

Besides, the N,N,N',N'-tetraarylbenzidine compounds are also not specifically restricted, but are preferably compounds represented by the formula (2).

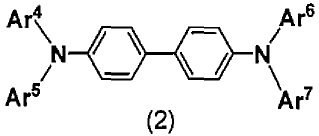

In the formula (2), Ar⁴ to Ar⁷ each independently represent an aryl group which has 6 to 20 carbon atoms and may be substituted with Z¹, provided that, in this case also, at least one of ring-forming carbon atoms in each of Ar⁴ to Ar⁷ is unsubstituted (namely, accompanied by a hydrogen atom on the carbon atom), since the aryl group having 6 to 20 carbon atoms must have a portion which contributes to a condensation reaction with the aldehyde compound or the fluorene derivative.

Note that examples of the aryl group include the same groups as mentioned above as examples in relation to the above formula (1); in this case also, the aryl group is preferably a phenyl group which may be substituted with Z¹.

In addition, examples of Z¹ include the same atoms and groups as mentioned above as examples in relation to the above formula (1), among which preferred are the halogen atoms, the nitro group, the cyano group, and the alkyl groups which have 1 to 20 carbon atoms and may be substituted with Z⁵, more preferred are the halogen atoms and alkyl groups which have 1 to 4 carbon atoms and may be substituted with Z⁵, and the most suitable is the absence (namely, that Ar⁴ to Ar⁷ are each an unsubstituted aryl group), wherein preferred as the substituent Z⁵ is a halogen atom, more preferred is a fluorine atom, and the most suitable is the absence (namely, non-substitution with Z⁵).

Specific examples of the N,N,N',N'-tetraarylbenzidine compounds include, N,N,N',N'-tetraphenylbenzidine compounds represented by formula (8).

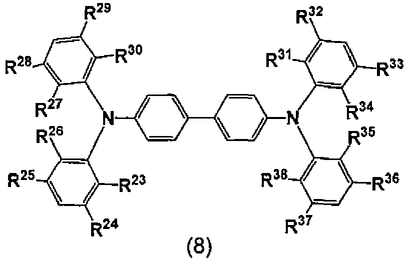

In the formula (8), R²³ to R³⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵. Here, examples of the halogen atom, the alkyl group, the alkenyl group, the alkynyl group and Z⁵ include the same atoms and groups as above-mentioned.

Preferred as R²³ to R³⁸ are the hydrogen atom, the halogen atoms, the nitro group, the cyano group, and the alkyl groups which have 1 to 20 carbon atoms and may be substituted with Z⁵, more preferred are the hydrogen atom, a fluorine atom, and alkyl groups which have 1 to 4 carbon atoms and may be substituted with Z⁵, and the most suitable is that all the R²³ to R³⁸ are hydrogen atoms.

Besides, in the N,N,N',N'-tetraarylbenzidine compound having at least one aryl group substituted with an alkoxy group which may include an ether linkage, the alkoxy group which may include the ether linkage is not particularly limited, but is preferably an alkoxy group (substituent Z²) which has 1 to 20 carbon atoms and may include the ether linkage; therefore, the N,N,N',N'-tetraarylbenzidine compound substituted with the alkoxy group is preferably any one represented by formula (3).

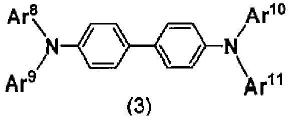

In the formula (3), Ar⁸ to Ar¹¹ each independently represent an aryl group which has 6 to 20 carbon atoms and may be substituted with Z². In this case, also, at least one of ring-forming carbon atoms in at least two of Ar⁸ to Ar¹¹ is unsubstituted, and at least one of Ar⁸ to Ar¹¹ is substituted with Z², for the same reason as above-mentioned. Here, examples of the aryl group having 6 to 20 carbon atoms include the same groups as above-mentioned, among which preferred is the phenyl group.

Specific examples of Z² include OCH₃, OCH₂OCH₃, OCH₂OCH₂CH₃, OCH₂O(CH₂)₂CH₃, OCH₂OCH(CH₃)₂, OCH₂O (CH₂)₃CH₃, OCH₂OCH₂CH(CH₃)₂, OCH₂OC(CH₃)₃, OCH₂O(CH₂)₄CH₃, OCH₂OCH(CH₃)(CH₃)₂CH₃, OCH₂O(CH₂)₂CH(CH₃)₂, OCH₂OCH(CH₃)(CH₂)₃CH₃, OCH₂O(CH₂)₅CH₃, OCH₂OCH₂CH(CH₃)(CH₂)₂CH₃, OCH₂O (CH₂)₂CH(CH₃)CH₂CH₃, OCH₂O(CH₂)₃CH(CH₃)₂, OCH₂OC(CH₃)₂(CH₂)₂CH₃, OCH₂OCH(CH₂CH₃)(CH₂)₂CH₃, OCH₂OC(CH₃)₂CH(CH₃)₂, OCH₂O (CH₂)₆CH₃, OCH₂O(CH₂)₇CH₃, OCH₂OCH₂CH(CH₂CH₃)(CH₂)₃CH₃, OCH₂O(CH₂)₈CH₃, OCH₂O(CH₂)₉CH₃, OCH₂O(CH₂)₁₀CH₃, OCH₂O(CH₂)ₙCH₃, OCH₂O(CH₂)₁₂CH₃, OCH₂O(CH₂)₁₃CH₃, OCH₂O(CH₂)₁₄CH₃, OCH₂O(CH₂)₁₅CH₃, OCH₂O(CH₂)₁₆CH), OCH₂O(CH₂)₁₇CH₃, OCH₂O(CH₂)₁₈CH₃, OCH₂CH₂OCH₃, OCH₂CH₂OCH₂CH₃, OCH₃CH₃O(CH₂)₂CH₃, OCH₂CH₂OCH(CH₃)₂, OCH₃CH₃O(CH₂)₃CH₃, OCH₂CH₂OCH₂CH(CH3)₂, CH₂CH₂OC(CH₃)₃, OCH₃CH₃O(CH₂)₄CH₃, OCH₂CH₂OCH(CH₃)(CH₂)₂CH₃, OCH₂CH₂OCH₂CH(CH₃)₂, OCH₃CH₃O(CH₂)₂CH(CH₃)₂, OCH₂CH₂OC(CH₃)₃, OCH₂CH₂OCH(CH₃)(CH₂)₃CH₃, OCH₃CH₃O(CH₂)₅CH₃, OCH₂CH₂OCH(CH₃)(CH₂)₃CH₃, OCH₂CH₂OCH₂CH(CH₃)(CH₂)₂CH₃, OCH₃CH₃O(CH₂)₂CH(CH₃)CH₂CH₃, OCH₃CH₃O(CH₂) ₃CH(CH₃)₃, OCH₂CH₂OC(CH₃)₂(CH₂)₂CH₃, OCH₂CH₂OCH(CH₂CH₃)(CH₂)₂CH₃, OCH₂CH₂OC(CH₃)₂CH(CH₃)₂, OCH₃CH₃O(CH₂)₆CH₃, OCH₃CH₃O(CH₂)₇CH₃, OCH₂CH₂OCH₂CH(CH₂CH₃) (CH₂)₃CH₃, OCH₂CH₂O(CH₂)₈CH₃, OCH₂CH₂O(CH₂)₉CH₃, OCH₂CH₂O(CH₂)₁₀CH₃, OCH₂CH₂O(CH₂)₁₁CH₃, OCH₂CH₂O(CH₂)₁₂CH₃, OCH₂CH₂O(CH₂)₁₃CH₃, OCH₃CH₃O(CH₂)₁₄CH₃, OCH₃CH₃O(CH₂)₁₅CH₃, OCH₂CH₂O(CH₂)₁₆CH₃, OCH₃CH₃O(CH₂)₁₇CH₃, OCH₂CH₂CH₂OCH₃, OCH₂CH₂CH₂OCH₂CH₃, OCH₂CH₂CH₂O(CH₂)₂CH₃, OCH₂CH₂CH₂OCH(CH₃)₂, OCH₂CH₂CH₂O(CH₂)₃CH₃, OCH₂CH₂CH₂OCH₂CH(CH₃)₂, OCH₂CH₂CH₂OC(CH₃)₃, OCH₂CH₂CH₂O(CH₂)₄CH₃, OCH₂CH₂CH₂OCH(CH₃)(CH₂)₃CH₃, OCH₂CH₂CH₂OCH₂CH(CH₃)₂, OCH₂CH₂CH₂O(CH₂)₂CH(CH₃)₂, OCH₂CH₂CH₂OC(CH₃)₃, OCH₂CH₂CH₂OCH(CH₃)(CH₂)₃CH₃, CH₂CH₂CH₂O(CH₂)₅CH₃, OCH₂CH₂CH₂OCH(CH₃)(CH₂)₃CH₃, OCH₂CH₂CH₂OCH₂CH(CH₃)(CH₂)₂CH₃, OCH₂CH₂CH₂O(CH₂)₂CH(CH₃)CH₂CH₃, OCH₂CH₂CH₂O(CH₂)₃CH(CH₃)₂, OCH₂CH₂CH₂OC(CH₃)₂(CH₂)₂CH₃, OCH₂CH₂CH₂OCH(CH₂CH₃)(CH₂)₂CH₃, OCH₂CH₂CH₂OC(CH₃)₂CH(CH₃)₂, OCH₂CH₂CH₂O(CH₃)₆CH₃, OCH₂CH₂CH₂O(CH₂)₇CH₃, OCH₂CH₂CH₂OCH₂CH(CH₂CH₃)(CH₂)₃CH₃, OCH₂CH₂OCH₂CH₂OCH₃, OCH₂CH₂OCH₂CH₂OCH₂CH₂OCH₃, OCH₂CH₂OCH₂CH₂OCH₂CH₂OCH₂CH₂OCH₃, OCH₂CH₂OCH₂CH₂OCH₂CH₂OCH₂CH₂OCH₂CH₂OCH₃, OCH₂CH₂OCH₂CH₂OCH₂CH₂OCH₂CH₂OCH₂CH₂OCH₂CH₂OCH₃, OCH₂CH₂OCH₂CH₂OCH₂CH₂OCH₂CH₂OCH₂CH₂OCH₂CH₂OCH₂CH₂OCH₃, OCH₂CH₂OCH₂CH₂OCH₂CH₂OCH₂CH₂OCH₂CH₂OCH₂CH₂OCH₂CH₂OCH₂CH₂OCH₃, OCH₂CH₂CH₂OCH₂CH₂CH₂OCH₃, OCH₂CH₂CH₂OCH₂CH₂CH₂OCH₂CH₂CH₂OCH₃, OCH₂CH₂CH₂OCH₂CH₂CH₂OCH₂CH₂CH₂OCH₂CH₂CH₂OCH₃, CH₂CH₂CH₂OCH₂CH₂CH₂OCH₂CH₂CH₂OCH₂CH₂CH₂OCH₂CH₂CH₂OCH₃, OCH₂CH₂CH₂OCH₂CH₂CH₂OCH₂CH₂CH₂OCH₂CH₂CH₂OCH₂CH₂CH₂OCH₂CH₂CH₂OCH₃, OCH₂CH₂CH₂CH₂OCH₂CH₂CH₂CH₂OCH₂CH₂CH₂CH₂OCH₃, OCH₂CH₂CH₂CH₂OCH₂CH₂CH₂CH₂OCH₂CH₂CH₂CH₂OCH₂CH₂CH₂CH₂OCH₃, OCH₂CH₂OCH₂CH₂OCH₂CH₂OCH₂CH₂OCH₂CH₂OCH₂CH₂OCH₂CH₃, OCH₂CH₂OCH₂CH₂OCH₂CH₂OCH₂CH₂OCH₂CH₂OCH₂CH₂OCH₂CH₂OCH₂CH₃, OCH₂CH₂OCH₂CH₂OCH₂CH₂OCH₂CH₂OCH₂CH₂OCH₂CH₂OCH₂CH₂OCH₂CH₂OCH₂CH₃, OCH₂CH₂OCH₂CH₂OCH₂CH₃, OCH₂CH₂OCH₂CH₂OCH₂CH₂OCH₂CH₃, OCH₂CH₂CH₂O(CH₂)₈CH₃, OCH₂CH₂CH₂O(CH₂)₉CH₃, OCH₂CH₂CH₂O(CH₂)₁₀CH₃, OCH₂CH₂CH₂O(CH₂)₁₁CH₃, OCH₂CH₂CH₂O(CH₂)₁₂CH₃, OCH₂CH₂CH₂O(CH₂)₁₃CH₃, OCH₂CH₂CH₂O(CH₂)₁₄CH₃, CH₂CH₂CH₂O(CH₂)₁₅CH₃, and OCH₂CH₂CH₂O(CH₂)₁₆CH₃ groups. Among these, preferred are alkoxy groups having 2 to 15 carbon atoms and including an ether linkage, and more preferred are alkoxy groups having 5 to 10 carbon atoms and including an ether linkage.

The number of the alkoxy groups which may include the ether linkage may be at least one, but, from the viewpoint of enhancing solubility in organic solvents, and luminance characteristics of the organic EL element obtained, the number is preferably at least two.

Particularly, where the number is two, the two alkoxy groups are preferably present in aryl groups on different nitrogen atoms; for example, N,N,N',N'-tetraphenylbenzidine compounds represented by formula (9-1) are preferable.

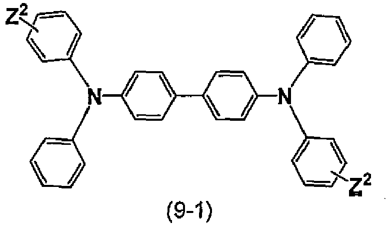

Here, Z² is an alkoxy group which has 1 to 20 carbon atoms and may include an ether linkage, specific examples of which include the groups mentioned above as examples. Particularly, preferred as Z² are straight-chain groups having 3 to 21 carbon atoms, and more preferred are straight-chain groups having 5 to 10 carbon atoms. Therefore, for example, N,N,N',N'-tetraphenylbenzidine compounds represented by formula (9-2) are preferable.

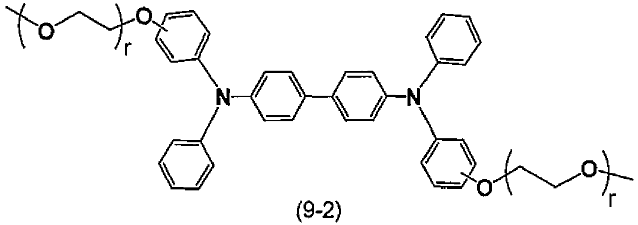

The above letters r each independently represent an integer of 1 to 10, preferably an integer of 1 to 5.

In addition, the substitution position of Z² may be any position, but is preferably a meta-position or a para-position with respect to the nitrogen atom. More preferably, the two Z² groups are both at meta-positions or both at para-positions, as represented by formula (9'-1), formula (9'-2), formula (9"-1) and formula (9"-2). 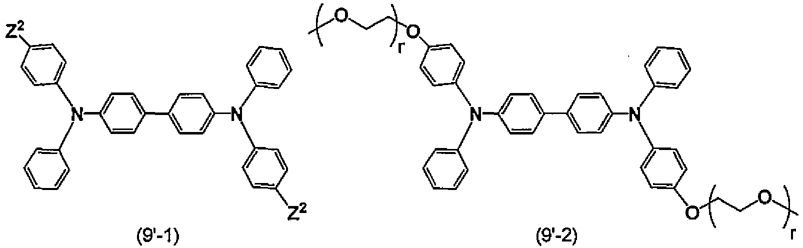 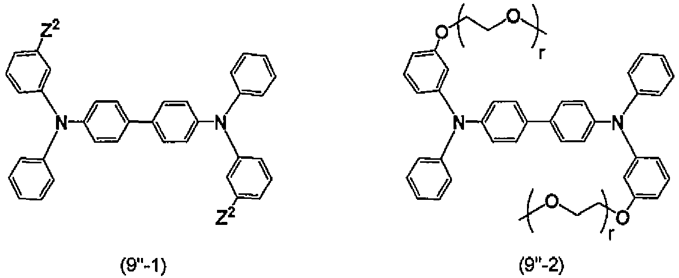 (In the formulas, Z² and letter r have the same meanings as above-mentioned.)

Particularly preferable examples of the N,N,N',N'-tetraphenylbenzidine compound include the compounds represented by formulas (10-1) to (10-8).

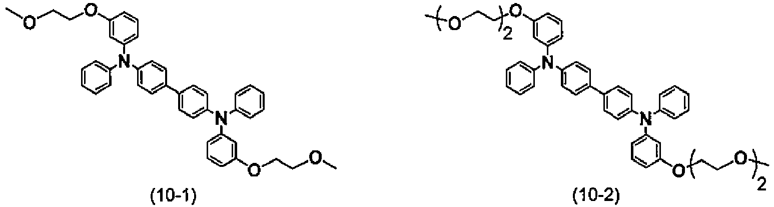

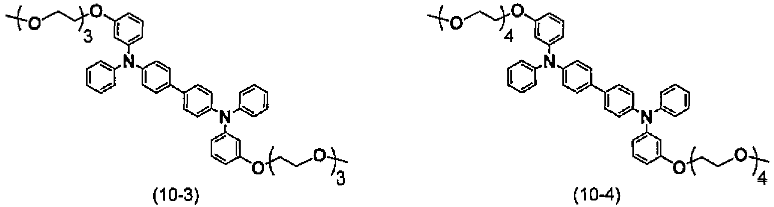

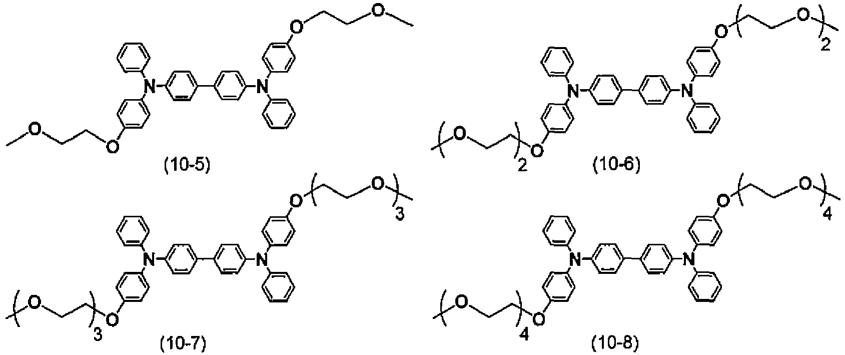

Further, the fluorine-containing aryl aldehyde compound is preferably a compound represented by formula (4).

Ar¹²-CHO (4)

In the formula (4), Ar¹² represents an aryl group which has 6 to 20 carbon atoms and may be substituted with at least one Z³ and which may be substituted with Z⁴, and examples of this aryl group include the same aryl groups as above-mentioned.

The substituent Z³ represents a fluorine atom, a fluorinated alkyl group having 1 to 20 carbon atoms, or a fluorinated aryl group having 6 to 20 carbon atoms; Z⁴ represents a chlorine atom, a bromine atom, an iodine atom, a nitro group, a cyano group, or an alkyl group having 1 to 20 carbon atoms, alkenyl group having 2 to 20 carbon atoms or alkynyl group having 2 to 20 carbon atoms which may be substituted with Z⁶, and Z⁶ represents a chlorine atom, a bromine atom, an iodine atom; a nitro group, or a cyano group.

Examples of the fluorinated alkyl group having 1 to 20 carbon atoms and fluorinated aryl group having 6 to 20 carbon atoms include groups obtained by substituting with a fluorine atom at least one of the hydrogen atoms on the carbon atoms of the above-mentioned alkyl groups having 1 to 20 carbon atoms and aryl groups having 6 to 20 carbon atoms.

Further, examples of the alkyl group, alkenyl group and alkynyl group include the same alkyl, alkenyl and alkynyl groups as above-mentioned.

Among these, preferred as Z³ are the fluorine atom and fluorinated alkyl groups having 1 to 10 carbon atoms, more preferred are the fluorine atom and fluorinated alkyl groups having 1 to 4 carbon atoms, and still more preferred are the fluorine atom and perfluoroalkyl groups having 1 to 4 carbon atoms.

In addition, preferred as Z⁴ are alkyl groups which have 1 to 20 carbon atoms and may be substituted with Z⁶, more preferred are alkyl groups which have 1 to 10 carbon atoms and may be substituted with Z⁶, still more preferred are alkyl groups which have 1 to 4 carbon atoms and may be substituted with Z⁶, and further preferred is the absence (namely, non-substitution with Z⁴).

Besides, preferred as Z⁶ is a chlorine atom or a bromine atom, and more preferred is the absence (namely, non-substitution with Z⁶).

Specific examples of the fluorinated alkyl group include trifluoromethyl, pentafluoroethyl, 2,2,2-trifluoroethyl, heptafluoropropyl, 2,2,3,3,3-pentafluoropropoyl, 2,2,3,3-tetrafluoropropyl, 2,2,2-trifluoro-1-(trifluoromethyl)ethyl, nonafluorobutyl, 4,4,4-trifluorobutyl, undecafluoropentyl, 2,2,3,3,4,4,5,5,5-nonafluoropentyl, 2,2,3,3,4,4,5,5-octafluoropentyl, tridecafluorohexyl, 2,2,3,3,4,4,5,5,6,6,6-undecafluorohexyl, 2,2,3,3,4,4,5,5,6,6-decafluorohexyl, and 3,3,4,4,5,5,6,6,6-nonafluorohexyl.

Specific examples of the fluorinated aryl group include 4-fluoropohenyl, 2,3-difluorophenyl, 2,4-difluorophenyl, 2,5-difluoropohenyl, 2,6-difluorophenyl, pentafluorophenyl, 1-fluoro-2-naphthyl, 1-fluoro-3-naphthyl, 1-fluoro-4-naphthyl, 1-fluoro-5-naphthyl, 1-fluoro-6-naphthyl, 1-fluoro-7-naphthyl, 1-fluoro-8-naphthyl, 2-fluoro-1-naphthyl, 2-fluoro-3-naphthyl, 2-fluoro-4-naphthyl, 2-fluoro-5-naphthyl, 2-fluoro-6-naphthyl, 2-fluoro-7-naphthyl, 2-fluoro-8-naphthyl, and perfluoronaphthyl.

Specific examples of the aryl aldehyde compound include benzaldehyde derivatives represented by formula (11) or formula (12).

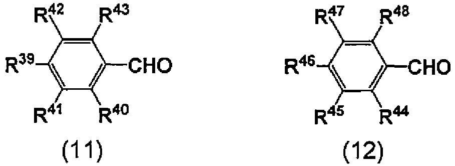

In the formula (11), R³⁹ represents a fluorine atom or a fluorinated alkyl group having 1 to 20 carbon atoms, and R⁴⁰ to R⁴³ each represent a hydrogen atom, a nitro group, a cyano group, or an alkyl group which has 1 to 20 carbon atoms and may be substituted with a nitro group or a cyano group. Examples of the fluorinated alkyl group and alkyl group include the same fluorinated alkyl groups and alkyl groups as above-mentioned.

Among these, preferred as R³⁹ are the fluorine atom and fluorinated alkyl groups having 1 to 10 carbon atoms, more preferred are the fluorine atom and fluorinated alkyl groups having 1 to 4 carbon atoms, still more preferred are the fluorine atom and perfluoroalkyl groups having 1 to 4 carbon atoms, and further preferred are the fluorine atom and trifluoromethyl.

In addition, preferred as R⁴⁰ to R⁴³ are the hydrogen atom and unsubstituted alkyl groups having 1 to 20 carbon atoms, more preferred are the hydrogen atom and unsubstituted alkyl groups having 1 to 10 carbon atoms, still more preferred are the hydrogen atom and unsubstituted alkyl groups having 1 to 4 carbon atoms, further preferred are the hydrogen atom and methyl, and the most preferred is that all the R⁴⁰ to R⁴³ are hydrogen atoms.

In the formula (12), R⁴⁴ to R⁴⁸ each independently represent a fluorine atom or a fluorinated alkyl group having 1 to 20 carbon atoms. Examples of the fluorinated alkyl group include the same fluorinated alkyl groups as above-mentioned.

Among these, preferred as R⁴⁴ to R⁴⁸ are the fluorine atom and fluorinated alkyl group having 1 to 10 carbon atoms, more preferred are the fluorine atom and fluorinated alkyl group having 1 to 4 carbon atoms, still more preferred are the fluorine atom and perfluoroalkyl group having 1 to 4 carbon atoms, further preferred are the fluorine atom and trifluoromethyl, and the most suitable is that all the R⁴⁴ to R⁴⁸ are fluorine atoms.

In addition, the fluorene derivative having the carbonyl group is preferably a compound represented by formula (5) or formula (6).

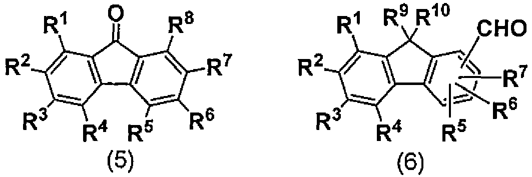

In the formula (5), R¹ to R⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵. Here, examples of the halogen atom, alkyl group, alkenyl group, alkynyl group and Z⁵ include the same atoms and groups as above-mentioned.

Among these, preferred as R¹ to R⁸ are the hydrogen atom, the fluorine atom, and alkyl groups which have 1 to 10 carbon atoms and may be substituted with Z⁵, more preferred are the hydrogen atom, the fluorine atom, and alkyl groups having 1 to 4 carbon atoms, and the most suitable is that all the R¹ to R⁸ are hydrogen atoms.

Besides, in the formula (6), R¹ to R⁷ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵, R⁹ and R¹⁰ each independently represent a hydrogen atom, an alkyl group having 1 to 20 carbon atoms, (poly)ethylene oxide group having 2 to 20 carbon atoms, alkenyl group having 2 to 20 carbon atoms or alkynyl group having 2 to 20 carbon atoms which may be substituted with Z⁵, or an alkyl group which has 1 to 20 carbon atoms and may be substituted with an ethenyl group or an ethynyl group and which may be substituted with Z⁵. Here, examples of the halogen atom, alkyl group, alkenyl group, alkynyl group and Z⁵ include the same atoms and groups as above-mentioned.

Among these, preferred as R¹ to R⁷ are the hydrogen atom, a fluorine atom, and alkyl groups which have 1 to 10 carbon atoms and may be substituted with Z⁵, more preferred are the hydrogen atom, the fluorine atom and alkyl groups having 1 to 4 carbon atoms, and the most suitable is that all the R¹ to R⁷ are hydrogen atoms.

In addition, preferred as R⁹ and R¹⁰ are the hydrogen atom and alkyl groups having 1 to 10 carbon atoms or (poly)ethylene oxide groups having 2 to 10 carbon atoms which may be substituted with Z⁵, more preferred are the hydrogen atom and alkyl group having 1 to 10 carbon atoms, and the most suitable is that both the R⁹ and R¹⁰ are hydrogen atoms.

Besides, preferred as the substituent Z⁵ is a halogen atom, more preferred is a fluorine atom, and the most suitable is the absence (namely, non-substitution with Z⁵).

The polymer of the triarylamine compound, the tetraarylbenzidine compound, the aryl aldehyde compound and the fluorene derivative as above-mentioned can be obtained by condensation polymerization in the presence of an acid catalyst.

In this reaction, the tetraarylbenzidine compound having an alkoxy group, the aldehyde compound and the fluorene derivative can be used in a total amount of approximately 0.01 to 10 equivalents, preferably 0.05 to 5 equivalents, more preferably 0.1 to 3 equivalents, per equivalent of the aryl groups in the triarylamine compound or the tetraarylbenzidine compound.

In this case, as for the ratio of the amounts of the aldehyde compound and the fluorene derivative used, normally, the fluorene derivative can be used in a proportion of approximately 0.1 to 20 equivalents, preferably 1 to 15 equivalents, more preferably 5 to 10 equivalents, based on one equivalent of the aldehyde compound.

Besides, as for the ratio of the amounts of the tetraarylbenzidine compound having an alkoxy group and the aldehyde compound used, normally, the tetraarylbenzidine compound having the alkoxy group can be used in a proportion of approximately 0.1 to 20 equivalents, preferably 1 to 15 equivalents, more preferably 5 to 10 equivalents, based on one equivalent of the aldehyde compound.

As the acid catalyst, there can be used, for example, mineral acids such as sulfuric acid, phosphoric acid, or perchloric acid, organic sulfonic acids such as p-toluenesulfonic acid or p-toluenesulfonic acid monohydrate, and carboxylic acids such as formic acid or oxalic acid.

The amount of the acid catalyst to be used is variously selected according to the kind of the acid catalyst. Normally, the acid catalyst is used in an amount of 0.001 to 10 equivalents, preferably 0.01 to 5 equivalents, more preferably 0.1 to 1 equivalent, based on one equivalent of the triarylamine compound or the tetraarylbenzidine compound.

Although the above condensation reaction can be carried out in the absence of solvent, the reaction is normally conducted by use of a solvent. Any solvent that does not hinder the reaction can be used. Examples of the usable solvent include: cyclic ethers such as tetrahydrofuran or 1,4-dioxane; amides such as N,N-dimethylformamide (DMF), N,N-dimethylacetamide (DMAc), or N-methyl-2-pyrrolidone (NMP); ketones such as methyl isobutyl ketone or cyclohexanone; halogenated hydrocarbons such as methylene chloride, chloroform, 1,2-dichloroethane, or chlorobenzene; and aromatic hydrocarbons such as benzene, toluene, or xylene. These solvents may be used either singly or by mixing at least two of them. Particularly, the cyclic ethers are preferable for use.

Besides, in the case where the acid catalyst to be used is a liquid, like, for example, formic acid, the acid catalyst can be made to play the role of a solvent.

A reaction temperature at the time of condensation is normally 40 to 200°C. A reaction time, which is appropriately set according to the reaction temperature, is normally approximately 30 minutes to approximately 50 hours.

The polymer obtained as above has a weight average molecular weight Mw of normally 500 to 200,000, preferably 1,000 to 200,000, more preferably 1,000 to 100,000, still more preferably 1,500 to 50,000, and further preferably 2,000 to 30,000.

As will be illustrated in Synthesis Example 2 described later, the N,N,N¹,N¹-1etraarylbenzidine compound represented by the formula (3) or the like and used in the present invention can be synthesized by reacting benzidine or the diphenylbenzidine compound with the aryl compound having the alkoxy group which may include an ether linkage and having a halogen atom or a pseudo-halogen group by a known coupling reaction conducted using a transition metal catalyst such as a palladium catalyst.

Note that examples of the halogen atom include iodine, bromine, or chlorine, and examples of the pseudo-halogen include: (fluoro)alkylsulfonyloxy such as methanesulfonyloxy, trifluoromethanesulfonyloxy, or nonafluorobutanesulfonyloxy; and aromatic sulfonyloxy such as benzenesulfonyloxy or toluenesulfonyloxy.

For example, the N,N,N',N'-tetraphenylbenzidine compounds represented by the formula (9-1) can be obtained by bringing N,N'-diphenylbenzidine and a halogenated or pseudo-halogenated benzene compound represented by formula (14) into a coupling reaction in the presence of a catalyst.

In addition, the N,N,N',N'-tetraphenylbenzidine compounds represented by the formula (9-2) can be obtained by using a halogenated or pseudo-halogenated benzene compound represented by formula (14') as the halogenated or pseudo-halogenated benzene compound represented by the formula (14). 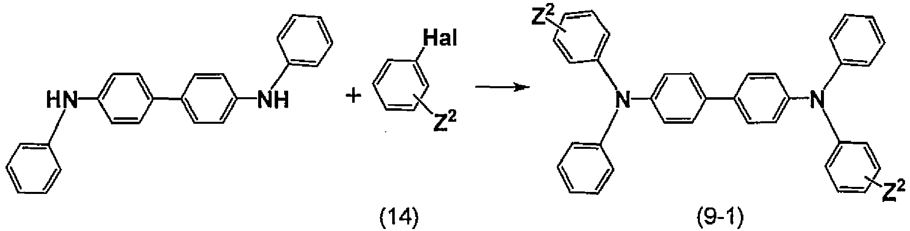 (In the formulas, Z² has the same meaning as above-mentioned. Hal represents a halogen atom or a pseudo-halogen group.) 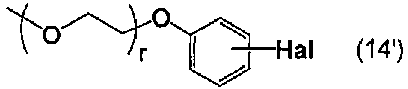 (In the formula, Hal and letter r have the same meanings as above-mentioned.)

Examples of the catalyst to be used in the coupling reaction include metal complexes such as: copper catalysts such as copper chloride, copper bromide, or copper iodide; and palladium catalysts such as [1,1'-bis(diphenylphosphino)-ferrocene]palladium(II)dichloride (PdCl₂(dppf)), tetrakis(triphenylphosphine)palladium(Pd(PPh₃)₄), bis(triphenylphosphine)dichloropalladium (Pd(PPh₃)₂Cl₂), bis(benzylideneacetone)palladium (Pd(dba)₂), tris(benzylideneacetone)dipalladium (Pd₂(dba)₃), bis(tri-t-butylphosphine)palladium (Pd(P-t-Bu₃)₂), or palladium acetate (Pd(OAc)₂).

These catalysts may be used either singly or in combination of at least two of them. In addition, those catalysts may be used together with a known appropriate ligand. Besides, a base such as t-butoxysodium may be used together with the catalyst.

The catalyst can be used in an amount of 0.0001 to 0.5 mol, preferably approximately 0.001 to 0.1 mol, per mol of the halogenated or pseudo-halogenated benzene compound.

Besides, in the case where a ligand is used, the amount of the ligand used can be 0.5 to 50 equivalents, preferably 1 to 10 equivalents, based on the metal complex used.

The charging ratio of the N,N'-diphenylbenzidine and the halogenated or pseudo-halogenated benzene compound represented by the formula (14) may be such that the total amount of "Hal" of the halogenated or pseudo-halogenated benzene compound is at least one equivalent, preferably approximately 1 to 1.2 equivalents, based on the total material amount of NH groups of the N,N'-diphenylbenzidine.

The above-mentioned coupling reaction is normally conducted in a solvent. The solvent is not particularly limited so long as it exerts no adverse influence on the reaction. Specific examples of the usable solvent include aliphatic hydrocarbons (pentane, n-hexane, n-octane, n-decane, and decalin), halogenated aliphatic hydrocarbon (chloroform, dichloromethane, dichloroethane and carbon tetrachloride), aromatic hydrocarbons (benzene, nitrobenzene, toluene, o-xylene, m-xylene, p-xylene, and mesitylene), ethers (diethyl ether, diisopropyl ether, t-butyl methyl ether, tetrahydrofuran (THF), dioxane, 1,2-dimethoxyethane, and 1,2-diethoxyethane), amides (N,N-dimethylformamide (DMF), and N,N-dimethylacetanmide), lactams and lactones (N-methylpyrrolidone, γ-butyrolactone), urea derivatives (N,N-dimethylimidazolidinone, and tetramethylurea), sulfoxides (dimethyl sulfoxide, and sulpholane), and nitriles (acetonitrile, propionitrile, and butyronitrile). These solvents may be used either singly or by mixing at least two of them.

A reaction temperature may be appropriately set within the range from the melting point to the boiling point of the solvent used. Particularly, the reaction temperature is preferably approximately 0 to approximately 200°C, more preferably 20 to 150°C.

After the reaction is over, an after-treatment may be conducted according to a usual method, whereby the desired N,N,N',N'-tetraarylbenzidine compound can be obtained.

In the charge-transporting varnish of the present invention, an oligoaniline compound is used as a non-fluorine-containing charge-transporting substance, together with the above-mentioned fluorine-containing charge-transporting substance composed of a polymer.

The oligoaniline compound is not specifically restricted, and can be selected from conventionally known oligoaniline compounds and used. In the present invention, however, it is preferable to use an oligoaniline compound represented by formula (13).

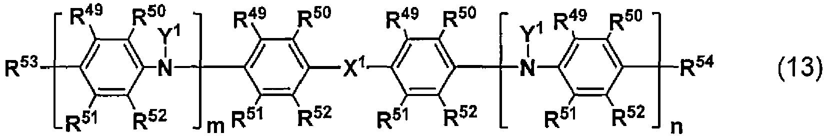

In the formula (13), R⁴⁹ to R⁵⁴ each independently represent a hydrogen atom, a halogen atom (exclusive of a fluorine atom), a nitro group, a cyano group, an alkyl group having 1 to 20 carbon atoms, alkenyl group having 2 to 20 carbon atoms or alkynyl group having 2 to 20 carbon atoms which may be substituted with Z⁷, an aryl group having 6 to 20 carbon atoms or heteroaryl group having 2 to 20 carbon atoms which may be substituted with Z⁸, -NHY², -NY³Y⁴, -C(O)Y⁵, -OY⁶, -SY⁷, -SO₃Y⁸, -C(O)OY⁹, -OC(O)Y¹⁰, -C(O)NHY¹¹, or -C(O)NY¹²Y¹³ group; Y² to Y¹³ each independently represent an alkyl group having 1 to 20 carbon atoms, alkenyl group having 2 to 20 carbon atoms or alkynyl group having 2 to 20 carbon atoms which may be substituted with Z⁷, or an aryl group having 6 to 20 carbon atoms or heteroaryl group having 2 to 20 carbon atoms which may be substituted with Z⁸, X¹ represents -NY¹-, -O-, -S-, -(CR⁵⁵R⁵⁶)ₗ- or a single bond; R⁵⁵ and R⁵⁶ have the same meaning as the R⁴⁹; letter 1 is an integer of 1 to 20; Y¹ each independently represents a hydrogen atom, an alkyl group having 1 to 20 carbon atoms, alkenyl group having 2 to 20 carbon atoms or alkynyl group having 2 to 20 carbon atoms which may be substituted with Z⁷, or an aryl group having 6 to 20 carbon atoms or heteroaryl group having 2 to 20 carbon atoms which may be substituted with Z⁸; Z⁷ represents a halogen atom (exclusive of a fluorine atom), a nitro group, a cyano group, or an aryl group having 6 to 20 carbon atoms or heteroaryl group having 2 to 20 carbon atoms which may be substituted with Z⁹; Z⁸ represents a halogen atom (exclusive of a fluorine atom), a nitro group, a cyano group, or an alkyl group having 1 to 20 carbon atoms, alkenyl group having 2 to 20 carbon atoms or alkynyl group having 2 to 20 carbon atoms which may be substituted with Z⁹; Z⁹ represents a halogen atom (exclusive of a fluorine atom), a nitro group, or a cyano group; m and n are each an integer of 1 to 10, satisfying m+n ≤ 10.

Specific examples of the heteroaryl group having 2 to 20 carbon atoms include 2-thienyl, 3-thienyl, 2-furanyl, 3-furanyl, 2-oxazolyl, 4-oxazolyl, 5-oxazolyl, 3-isooxazolyl, 4-isooxazolyl, 5-isooxazolyl, 2-thiazolyl, 4-thiazolyl, 5-thiazolyl, 3-isothiazolyl, 4-isothiazolyl, 5-isothiazolyl, 2-imidazolyl, 4-imidazolyl, 2-pyridyl, 3-pyridyl, or 4-pyridyl.

Further, examples of the halogen atom, the alkyl group, the alkenyl group, the alkynyl group and the aryl group include the same atoms and groups as above-mentioned.

In the formula (13), X¹ is preferably -NY¹- or the single bond.

Preferred as R⁴⁹ to R⁵² are the hydrogen atom, a chlorine atom, a bromine atom, the nitro group, the alkyl groups which have 1 to 20 carbon atoms and may be substituted with Z⁷, and the aryl groups which have 6 to 10 carbon atoms and may be substituted with Z⁸, more preferred are the hydrogen atom and alkyl groups having 1 to 10 carbon atoms, and the most suitable is that all the R⁴⁹ to R⁵² are hydrogen atoms.

Preferred as R⁵³ and R⁵⁴ are the hydrogen atom, a chlorine atom, a bromine atom, the nitro group, the alkyl groups which have 1 to 20 carbon atoms and may be substituted with Z⁷, aryl groups which have 6 to 10 carbon atoms and may be substituted with Z⁸, and the -NY³Y⁴ groups which are aryl groups having 6 to 20 carbon atoms wherein Y³ and Y⁴ may be substituted with Z⁸, more preferred are the hydrogen atom and diarylamino groups having 12 to 24 carbon atoms, and still more preferred is that R⁵³ and R⁵⁴ are simultaneously hydrogen atoms or diphenylamino groups.

Preferred as R⁵⁵ and R⁵⁶ are the hydrogen atom, the alkyl groups which have 1 to 20 carbon atoms and may be substituted with Z⁷, and the aryl groups which have 6 to 10 carbon atoms and may be substituted with Z⁸, more preferred are the hydrogen atom and alkyl groups having 1 to 10 carbon atoms, and the most suitable is that both R⁵⁵ and R⁵⁶ are hydrogen atoms.

Preferred as Y¹ are the hydrogen atom and the alkyl groups which have 1 to 20 carbon atoms and may be substituted with Z⁷, more preferred are the hydrogen atom and methyl, and the most suitable is the hydrogen atom. Note that the plurality of Y¹ groups may be identical or different from one another.

Particularly preferred is a combination wherein R⁴⁹ to R⁵² are each the hydrogen atom or an alkyl group having 1 to 10 carbon atoms, R⁵³ and R⁵⁴ are each the hydrogen atom or a diarylamino group having 12 to 24 carbon atoms, X¹ is -NY¹- or a single bond, and Y¹ is the hydrogen atom or methyl. More preferred is a combination wherein all the R⁴⁹ to R⁵² are hydrogen atoms, R⁵³ and R⁵⁴ are simultaneously hydrogen atoms or diphenylamino groups, X¹ is -NY¹- or the single bond, and Y¹ is the hydrogen atom.

Note that in Y¹ to Y¹³ and R⁴⁹ to R⁵⁶, preferred as the substituent Z⁷ are a chlorine atom, a bromine atom, the nitro group, the cyano group, and the aryl groups which have 6 to 20 carbon atoms and may be substituted with Z⁹, more preferred are the chlorine atom, the bromine atom, and a phenyl group which may be substituted with Z⁹, and the most suitable is the absence (namely, non-substitution with Z⁷).

In addition, preferred as the substituent Z⁸ are a chlorine atom, a bromine atom, the nitro group, the cyano group, and the alkyl groups which have 1 to 20 carbon atoms and may be substituted with Z⁹, more preferred are the chlorine atom, the bromine atom, and alkyl groups which have 1 to 4 carbon atoms and may be substituted with Z⁹, and the most suitable is the absence (namely, non-substitution with Z⁸).

Besides, preferred as Z⁹ is a chlorine atom and a bromine atom, and the most suitable is the absence (namely, non-substitution with Z⁹).

In the formula (13), m and n are each independently an integer of 1 to 10, satisfying m+n ≤ 10. Taking into account the balance between the charge-transporting properties of the thin film obtained and the solubility of the oligoaniline compound, however, it is preferable that m and n satisfy 2 ≤ m+n ≤ 8, it is more preferable that m and n satisfy 2 ≤ m+n ≤ 6, and it is still more preferable that m and n satisfy 2 ≤ m+n ≤ 4.

The molecular weight of the non-fluorine-containing oligoaniline compound is normally 300 to 5,000. From the viewpoint of enhancing the solubility, however, the molecular weight is preferably up to 4,000, more preferably up to 3,000, and still more preferably up to 2,000.

Note that the method for synthesizing the oligoaniline compounds to be used in the present invention is not particularly limited. Examples of the applicable synthesizing method include the methods described in Bulletin of Chemical Society of Japan, vol. 67, 1994, pp. 1749-1752, Synthetic Metals, vol. 84, 1997, pp. 119-120, or WO 2008/032617, WO 2008/032616, or WO 2008/129947.

Specific examples of the oligoaniline compounds represented by the formula (13) include, but are not limited to, the compounds represented by the following formulas.

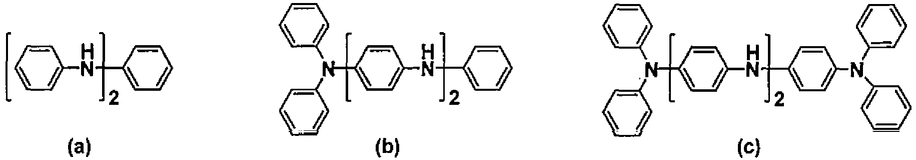

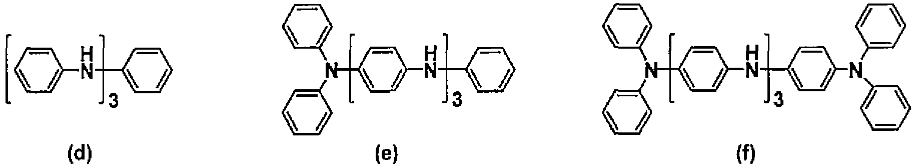

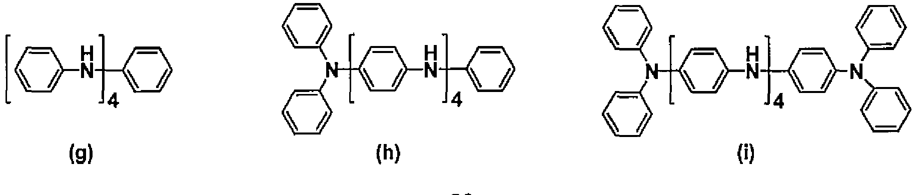

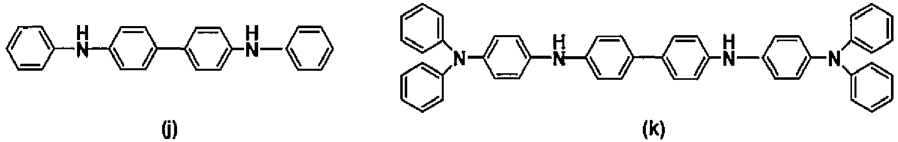

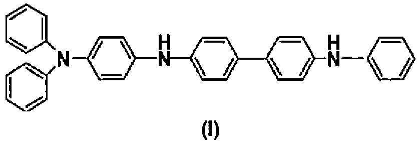

In the charge-transporting varnish of the present invention, the ratio of the amounts of the fluorine-containing charge-transporting substance and the non-fluorine-containing charge-transporting substance to be used is not particularly limited. From the viewpoint of enhancing the luminance characteristics of the organic EL element to be obtained, however, the weight ratio of the amount of the fluorine-containing charge-transporting substance to the amount of the non-fluorine-containing charge-transporting substance is preferably from approximately 0.1 to approximately 5, more preferably from approximately 0.5 to approximately 3, and still more preferably from approximately 0.5 to approximately 1.

The charge-transporting varnish of the present invention further contains a heteropoly-acid as a dopant substance.

The heteropoly-acid is a polyacid which has a structure including a hetero-atom located in the center of the molecule, represented typically by a Keggin type chemical structure of formula (A) or a Dawson type chemical structure of formula (B), and in which an isopoly acid as an oxyacid of vanadium (V), molybdenum (Mo), or tungsten (W) is condensed with an oxyacid of a different element. Major examples of the oxyacid of the different element include oxyacids of silicon (Si), phosphorus (P), and arsenic (As).

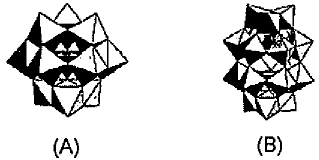

Specific examples of the heteropoly-acid include phosphomolybdic acid, silicomolybdic acid, phosphotungstic acid, silicotungstic acid, or phosphotungstomolybdic acid, which may be used either singly or in combination of at least two of them. Note that the heteropoly-acids to be used in the present invention are commercially available and can be synthesized by known methods.

In the present invention, from the viewpoint of enhancing the luminance characteristics of the organic EL element, preferred is phosphomolybdic acid or phosphotungstic acid, and more preferred is phosphotungstic acid.

Note that in the present invention, even when a quantitative analysis such as elemental analysis shows that a heteropoly-acid has a larger or smaller number of atoms of an element as compared with a structure represented by the general formula for the acid, the heteropoly-acid can be used in the present invention so long as the heteropoly-acid is obtained as a commercialized product or is synthesized appropriately according to a known synthetic method.

Specifically, for example, phosphotungstic acid is generally represented by the chemical formula H₃(PW₁₂O₄₀)·nH₂O, while phosphomolybdic acid is generally represented by the chemical formula H₃(PMo₁₂O₄₀)·nH₂O. Even when a heteropoly-acid has a structure such that the actual number of P (phosphorus), O (oxygen) or W (tungsten) or Mo (molybdenum) in the chemical formula is greater or smaller than the corresponding number in the general chemical formula, the heteropoly-acid can be used in the present invention so long as the heteropoly-acid is obtained as a commercialized product or is synthesized appropriately according to a known synthesizing method. In this case, the weight of the heteropoly-acid prescribed in the present invention does not mean the pure weight of phosphotungstic acid (phosphotungstic acid content) in the synthesized product or commercialized product, but means the total weight, in the state of including hydration water and other impurities, of the heteropoly-acid in the commercially available form and in the isolatable form according to the known synthetic method.

In the present invention, the weight ratio of the amount of the heteropoly-acid, preferably phosphotungstic acid, to the amount of the oligoaniline compound is set in the range from approximately 2 to approximately 10, preferably from approximately 2.5 to approximately 9.0, whereby a charge-transporting thin film which gives a high luminance when used in an organic EL element can be obtained with good reproducibility.

In other words, such a charge-transporting varnish ensures that the ratio of the weight (W_{D}) of the heteropoly-acid to the weight (W_{H}) of the oligoaniline compound satisfies 2 ≤ W_{D}/W_{H} ≤ 10, preferably 2.5 ≤ W_{D}/W_{H} ≤ 9.0.

In addition, the charge-transporting varnish of the present invention may contain a curing agent, for the purpose of enhancing the solvent resistance of the thin film obtained from the varnish.

Such a curing agent is not specifically restricted, and examples thereof include conventionally known various curing agents such as (meth)acrylate compounds, epoxy compounds, or compounds which have a blocked isocyanate group. Among these, preferred are acrylate-based curing agents such as (meth)acrylate compounds and compositions containing the same, and more preferred are polyfunctional acrylate-based curing agents such as polyfunctional (meth)acrylate compounds and compositions containing the same.

Specific examples of the acrylate-based curing agent include hexanediol di(meth)acrylate, neopentyl glycol di(meth)acrylate, triethylene glycol di(meth)acrylate, polyethylene glycol di(meth)acrylate, polypropylene glycol di(meth)acrylate, pentaerythritol di(meth)acrylate monostearate, bisphenol A ethylene glycol adduct (meth)acrylate, bisphenol F ethylene glycol adduct (meth)acrylate, tricyclo[5.2.1.0^{2,6}]decanemethanol di(meth)acrylate, trishydroxyethyl isocyanurate di(meth)acrylate, trimethylolpropane tri(meth)acrylate, trimethylolpropane ethylene glycol adduct tri(meth)acrylate, trimethylolpropane propylene glycol adduct tri(meth)acrylate, pentaerythritol tri(meth)acrylate, tris(meth)acryloyloxyethyl phosphate, trishydroxyethyl isocyanurate tri(meth)acrylate, modified ε-caprolactone tri(meth)acrylate, trimethylolpropane ethoxy tri(meth)acrylate, glycerine propylene glycol adduct tris(meth)acrylate, pentaerythritol tetra(meth)acrylate, pentaerythritol ethylene glycol adduct tetra(meth)acrylate, ditrimethylolpropane tetra(meth)acrylate, dipentaerythritol hexapenta(meth)acrylate, dipentaerythritolmonohydroxypenta(meth)acrylate, urethane (meth)acrylate, epoxy (meth)acrylate, polyester (meth)acrylate, unsaturated polyester, 9,9-bis[4-(2-acryloyloxyethoxy)phenyl]fluorene, OGSOL EA-0200, OGSOL EA-F5003, OGSOL EA-F5503, and OGSOL EA-F5510 (made by Osaka Gas Chemicals Co., Ltd.), NK-ESTER A-BPEF, and NK-ESTER A-BPEF/PGMAC70 (made by Shin-Nakamura Chemical Co., Ltd.).

In the case where a curing agent is used, the amount of the curing agent to be used is arbitrarily set so long as it imparts the desired solvent resistance to the thin film obtained and it has no adverse influence on the intrinsic characteristics such as charge-transporting properties of the thin film. The weight ratio of the amount of the curing agent to the total amount of the fluorine-containing charge-transporting substance, the non-fluorine-containing charge-transporting substance and the dopant substance composed of the heteropoly-acid is preferably in the range from approximately 0.01 to approximately 10, more preferably from approximately 0.05 to approximately 5.0, and still more preferably from approximately 0.10 to approximately 2.0.

As the solvent to be used in preparing the charge-transporting varnish, there can be used a high-solvency solvent capable of favorably dissolving the charge-transporting substances and the dopant substance therein. Examples of such a high-solvency solvent which can be used include such organic solvents as N,N-dimethylformamide, N,N-dimethylacetamide, N-methylpyrrolidone, 1,3-dimethyl-2-imidazolidinone, or diethylene glycol monomethyl ether. These solvents may be used either singly or by mixing at least two of them, the amount of which may be 5 to 100% by weight, based on the total amount of the solvents used in the varnish.

Note that it is preferable that both the charge-transporting substances and the dopant substance are completely dissolved or uniformly dispersed in the above-mentioned solvent.

Besides, the charge-transporting varnish of the present invention can contain at least one high-viscosity organic solvent having a viscosity of 10 to 200 mPa·s, particularly 35 to 150 mPa·s at 25°C and a boiling point of 50 to 300°C, particularly 150 to 250°C at normal pressure (atmospheric pressure). The addition of such a solvent makes it easy to prepare a varnish which accords to the coating method used and which gives a highly flat thin film with good reproducibility.

The high-viscosity organic solvent is not particularly limited, and examples thereof include cyclohexanol, ethylene glycol, 1,3-octylene glycol, diethylene glycol, dipropylene glycol, triethylene glycol, tripropylene glycol, 1,3-butanediol, 2,3-butanediol, 1,4-butanediol, propylene glycol, or hexylene glycol. These solvents may be used either singly or by mixing at least two of them.

The proportion of the high-viscosity organic solvent added, based on the total amount of the solvents used in the varnish of the present invention, is preferably in such a range that solid precipitation does not occur. The proportion of the high-viscosity organic solvent added is preferably 5 to 80% by weight, provided that solid precipitation does not occur.

Further, for the purpose of enhancing wettability with respect to a substrate, control of surface tension of the solvent, control of polarity, control of boiling point, etc., other solvents can also be mixed in a proportion of 1 to 90% by weight, preferably 1 to 50% by weight, based on the total amount of the solvents used in the varnish.

Examples of such solvents include, but are not limited to, ethylene glycol monobutyl ether, diethylene glycol diethyl ether, diethylene glycol dimethyl ether, diethylene glycol monoethyl ether acetate, diethylene glycol monobutyl ether acetate, dipropylene glycol monomethyl ether, propylene glycol monomethyl ether, propylene glycol monomethyl ether acetate, diethylene glycol monoethyl ether, diacetone alcohol, γ-butyrolactone, ethyl lactate, or n-hexyl acetate. These solvents can be used either singly or by mixing at least two of them.

The viscosity of the varnish of the present invention is appropriately set according to the thickness or the like of the thin film to be produced and the concentration of solid components. The viscosity is normally 1 to 50 mPa·s at 25°C.

In addition, the concentration of solid components of the charge-transporting varnish in the present invention is appropriately set taking into account the viscosity, surface tension of the varnish, and the thickness of the thin film to be produced. Normally, the concentration of solid components is approximately 0.1 to approximately 10.0% by weight, and, from the viewpoint of enhancing the coating properties of the varnish, the concentration is preferably 0.5 to 5.0% by weight, more preferably 1.0 to 3.0% by weight.

By applying the charge-transporting varnish of the present invention as above-described onto a substrate and baking the varnish, a charge-transporting thin film can be formed on the substrate.

The method of applying the varnish is not particularly limited, and examples thereof include a dipping method, a spin coating method, a slit coating method, a transfer printing method, a roll coating method, a brushing method, an ink jet method, or a spraying method. It is preferable to control the viscosity and surface tension of the varnish, according to the coating method (varnish-applying method).

Besides, in the case of using the varnish of the present invention, a braking atmosphere is also not specifically restricted. Not only in an atmospheric air but also in an inert gas such as nitrogen or in vacuum, it is possible to obtain a thin film which has a uniform film forming surface and charge-transporting properties. From the viewpoint of obtaining a thin film having a high charge-transporting property with good reproducibility, however, the baking atmosphere is preferably the atmospheric air.

A baking temperature is appropriately set within the range of generally 100 to 260°C, taking into account the use of the thin film to be obtained, the degree of charge-transporting properties to be imparted to the thin film to be obtained, etc. In the case where the thin film is provided between, and in contact with, an anode and a light-emitting layer of an organic EL element and is used as a functional single film (hole injection and transport layer), the baking temperature is preferably approximately 140 to 250°C, more preferably approximately 150 to 230°C. In this case, the baking may be conducted by changing the temperature at at least two stages, for the purpose of realizing a more uniform film-forming property or causing a reaction to progress on the substrate. The heating may well be carried out by use of an appropriate apparatus such as, for example, a hot plate or an oven.

The thickness of the charge-transporting thin film is not particularly limited. In the case where the charge-transporting thin film is used in an organic EL element, the thickness can be approximately 5 to 200 nm. From the viewpoint of enhancing the degree of phase separation of the two kinds of charge-transporting substances used in the present invention and thereby enhancing the luminance characteristics and lifetime characteristics of the organic EL element, however, the thickness is preferably 10 to 100 nm, more preferably 20 to 50 nm, and still more preferably 25 to 45 nm.

Examples of a method for varying the film thickness include a method in which the concentration of solid components in the varnish is varied, and a method in which the quantity of the solution on the substrate at the time of coating is varied.

In the case of producing an organic light-emitting diode (OLED) element by use of the charge-transporting varnish of the present invention, examples of materials to be used and of a method to be used include, but are not limited to, the followings.

Electrode substrates to be used are preferably cleaned beforehand by preliminarily washing with a detergent, an alcohol, or pure water. For example, an anode substrate is preferably subjected to a surface treatment such as a ultraviolet (UV) ozone treatment, or an oxygen-plasma treatment immediately before use. It is to be noted here, however, that such a surface treatment may not necessarily be carried out in the case where the anode material is composed mainly of an organic matter.

One example of the method of producing an OLED element having a functional single film (hole injection and transport layer) composed of a thin film obtained from the charge-transporting varnish of the present invention is as follows.

The charge-transporting varnish of the present invention is applied onto an anode substrate, and is baked by the above-mentioned method, to produce a functional single film on the electrode. This assembly is introduced into a vapor deposition apparatus, and then a light-emitting layer, an electron transport layer, an electron injection layer, and a cathode metal are sequentially vapor-deposited, to obtain an OLED element. A carrier blocking layer may be provided between arbitrary ones of the layers, for the purpose of controlling a light emission region.

Examples of the anode material include transparent electrodes typified by indium tin oxide (ITO) and indium zinc oxide (IZO). The anode material has preferably been subjected to a flattening treatment beforehand. Polythiophene derivatives and polyaniline derivatives which have high charge-transporting properties can also be used.

Examples of a material for forming the light-emitting layer include tris(8-quinolinolato)aluminum(III) (Alq₃), bis(8-quinolinolato)zinc(II) (Znq₂), bis(2-methyl-8-quinolinolato) (p-phenylphenolato)aluminum(III) (BAlq), and 4,4'-bis(2,2-diphenylvinyl)biphenyl (DPVBi). The light-emitting layer may be formed by co-evaporation of an electron-transporting material or a hole-transporting material together with a light-emitting dopant.

Examples of the electron-transporting material include Alq₃, BAlq, DPVBi, (2-(4-biphenyl)-5-(4-t-butylphenyl)-1,3,4-oxadiazole) (PBD), triazole derivatives (TAZ), bathocuproine (BCP), or silole derivatives.

Examples of the light-emitting dopant include quinacridone, rubrene, Coumarin 540, 4-(dicyanomethylene)-2-methyl-6-(p-dimethylaminostyryl)-4H-pyran (DCM), tris(2-phenylpyridine)iridium(III) (Ir(ppy)₃), or (1,10-phenanthroline)-tris(4,4,4-trifluoro-1-(2-thienyl)-butane-1,3-dionato)europium(III) (Eu(TTA)₃phen).

Examples of a material for forming the carrier blocking layer include PBD, TAZ, or BCP.

Examples of a material for forming the electron injection layer include lithium oxide (Li₂O), magnesium oxide (MgO), alumina (Al₂O₃), lithium fluoride (LiF), magnesium fluoride (MgF₂), strontium fluoride (SrF₂), Liq, Li(acac), lithium acetate, or lithium benzoate.

Examples of the cathode material include aluminum, magnesium-silver alloys, aluminum-lithium alloys, lithium, sodium, potassium, or cesium.

The method of producing a polymer light-emitting diode (PLED) element by use of the charge-transporting varnish of the present invention is not particularly limited, and examples thereof include the following method.

A PLED element having a functional single film (hole injection and transport layer) composed of a thin film obtained from the charge-transporting varnish of the present invention can be produced by forming a light-emitting polymer layer, in place of the operation of carrying out vapor deposition to form the light-emitting layer, the electron transport layer, and the electron injection layer in the above-mentioned OLED element production.

Specifically, the charge-transporting varnish of the present invention is applied onto an anode substrate to form the functional single film by the above-mentioned method, then the light-emitting polymer layer is formed thereon, and, further, a cathode is vapor-deposited, to obtain the PLED element.

As the cathode and anode materials to be used, the same materials as above-mentioned OLED element production can be used, and they can be subjected to the same cleaning treatment and surface treatment as above-mentioned OLED element production.

Examples of the method for forming the light-emitting polymer layer include a method in which a light-emitting polymer material or an admixture thereof with a dopant substance is admixed with a solvent to dissolve or uniformly disperse the polymer material (and the dopant, if used) in the solvent, and the resulting solution is applied onto the functional single film, followed by baking to form the desired film.

Examples of the light-emitting polymer material include polyfluorene derivatives such as poly(9,9-dialkylfluorenes) (PDAF), polyphenylenevinylene derivatives such as poly(2-methoxy-5-(2'-ethylhexoxy)-1,4-phenylenevinylene) (MEH-PPV), polythiophene derivatives such as poly(3-alkylthiophenes) (PAT), or polyvinylcarbazole (PVCz).

Examples of the solvent include toluene, xylene, or chloroform. Examples of the method for dissolution or uniform dispersion include such a method as stirring, stirring with heating, or ultrasonic dispersion.

The coating method is not particularly limited. Examples of the coating method include an ink jet method, a spraying method, a dipping method, a spin coating method, a transfer printing method, a roll coating method, or a brushing method. Note that the coating is preferably conducted in an inert gas such as nitrogen or argon.

Examples of a baking method include a method of heating in an inert gas or in vacuum by use of an oven or a hot plate.

### EXAMPLES

The present invention will be described more specifically below by illustrating Synthesis Examples, Examples and Comparative Examples, but the invention is not limited to the following Examples. Note that the apparatuses which were used are as follows.
(1) NMR: ECX-300, made by JEOL Ltd.
(2) LC/MS: ZQ 2000, made by Waters Corporation
(3) Substrate cleaning:
   Substrate cleaning apparatus (vacuum plasma system), made by Choshu Industry Co., Ltd.
(4) Application of varnish:
   Spin coater MS-A100, made by Mikasa Co., Ltd.
(5) Film thickness measurement:
   Microfigure measuring instrument SURF-CORDER ET-4000, made by Kosaka Laboratory Ltd.
(6) Polymer molecular weight measurement:
   Column: SHODEX GPC KF-803L + GPC KF-804L,
   made by Shimadzu Corporation, column temperature: 40°C, detector: UV detector (254 nm) and radioisotope (RI) detector, eluent: THF, column flow rate: 1.0 ml/minute
(7) Production of EL element:
   Multifunction deposition apparatus system C-E2L1G1-N, made by Choshu Industry Co., Ltd.
(8) Measurement of luminance, etc. of EL element:
   I-V-L measurement system, made by Tech World Inc.

### [1] Synthesis of Compound

### [Synthesis Example 1] Synthesis of compound 1

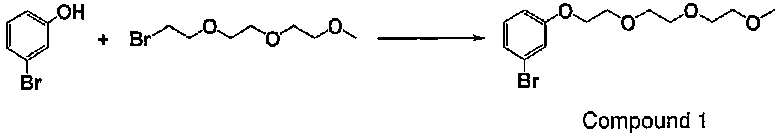

To 170 mL of an acetonitrile solution containing 8.65 g (50 mmol) of 3-bromophenol, were added 7.60 g (55 mmol) of potassium carbonate and 9,535 µL (55 mmol) of diethylene glycol 2-bromoethyl methyl ether, followed by stirring at room temperature for 18 hours and heating at reflux for seven hours. To the resulting suspension were added 1.50 g (10 mmol) of potassium carbonate and 1,900 µL (10 mmol) of diethylene glycol 2-bromoethyl methyl ether, followed by further heating at reflux for four hours. After the reaction was over, the insoluble matter was removed by filtration, and the filtrate was concentrated to obtain a crude product, which was purified by silica gel column chromatography (eluent: hexane/ethyl acetate), to obtain 16.13 g of a colorless liquid compound 1 (yield: 100%).
¹H-NMR (300 MHz, CDCl₃):
   δ 3.38 (s, 3H), 3.53-3.58 (m, 2H), 3.64-3.75 (m, 6H), 3.84 (app t, J = 4.8 Hz, 2H), 4.11 (app t, J = 4.8 Hz, 2H), 6.83-6.87 (m, 1H), 7.05-7.16 (m, 3H).
LC/MS (ESI⁺) m/z; 319, 321 [M+1]⁺

### [Synthesis Example 2] Synthesis of compound 2

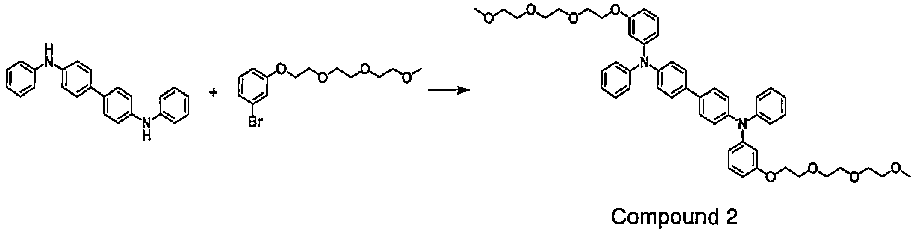

To 70 mL of a toluene suspension containing 4.88 g (14.5 mmol) of N,N'-diphenylbenzidine and 11.15 g (35 mmol) of the compound 1 obtained in Synthesis Example 1, were added 834 mg (1.5 mmol) of Pd(dba)₂, 4.18 g (43.5 mmol) of t-BuONa, 841 mg (2.9 mmol) of [(t-Bu)₃PH]BF₄ and 30 mL of toluene, followed by flushing with nitrogen, and heating at reflux for three hours. After the reaction was over, celite filtration was conducted, and the filtrate was concentrated to obtain a crude product, which was purified by silica gel column chromatography (eluent: hexane/ethyl acetate), to obtain 12.06 g of a brown liquid compound 2 (yield: 100%).
¹H-NMR (300 MHz, CDCl₃):
   δ 3.36 (s, 6H), 3.52-3.55 (m, 4H), 3.62-3.73 (m, 12H), 3.80 (app t, J = 4.8 Hz, 4H), 4.04 (app t, J = 4.8 Hz, 4H), 6.57-6.59 (m, 2H), 6.68-6.71 (m, 4H), 7.02 (app t, J = 7.2 Hz, 2H), 7.11-7.17 (m, 10H), 7.23-7.28 (m, 4H), 7.44 (d, J = 8.7 Hz, 4H).
LC/MS (ESI⁺) m/z; 813 [M+1]⁺

### [Synthesis Example 3] Synthesis of compound 3

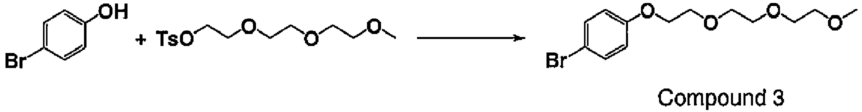

To 173 mL of an acetonitrile solution containing 8.65 g (50 mmol) of 4-bromophenol and 19.1 g (60 mmol) of 2-(2-(2-methoxyethoxy)ethoxy)ethyl p-toluenesulfonate synthesized by the method described in Macromolecules vol. 34, 2001, p.931, was added 8.29 g (60 mmol) of potassium carbonate, followed by heating at reflux for 23 hours. After the reaction was over, the insoluble matter was removed by filtration, and the filtrate was concentrated to obtain a crude product, which was purified by silica gel column chromatography [eluent: hexane/ethyl acetate (2/1 → 1/1 (v/v))], to obtain 15.24 g of a colorless liquid compound 3 (yield: 95%).
¹H-NMR (300 MHz, CDCl₃):
   δ 3.38 (s, 3H), 3.53-3.58 (m, 2H), 3.63-3.75 (m, 6H), 3.84 (app t, J = 4.8 Hz, 2H), 4.09 (app t, J = 4.8 Hz, 2H), 6.79 (d, J = 9.3 Hz, 2H), 7.35 (d, J = 9.0 Hz, 2H).
LC/MS (ESI⁺) m/z; 319, 321 [M+1]⁺

### [Synthesis Example 4] Synthesis of compound 4

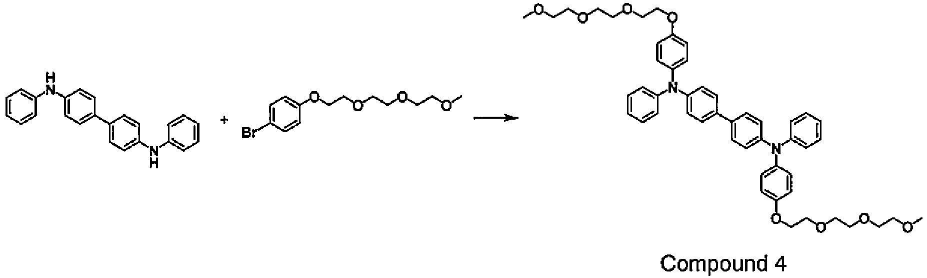

Using 4.73 g (14.1 mmol) of N,N'-diphenylbenzidine, 10.77 g (33.7 mmol) of the compound 3 obtained in Synthesis Example 3, 808 mg (1.4 mmol) of Pd(dba)₂, 4.05 g (42 mmol) of t-BuONa, and 670 µL (2.8 mmol) of di-t-butylphenylphosphine, synthesis was conducted by the same procedure as in Synthesis Example 2, to obtain 11.35 g of a brown liquid compound 4 (yield: 99%).
¹H-NMR (300 MHz, CDCl₃):
   δ 3.38 (s, 6H), 3.54-3.57 (m, 4H), 3.65-3.77 (m, 12H), 3.86 (app t, J = 4.8 Hz, 4H), 4.12 (app t, J = 4.8 Hz, 4H), 6.86 (d, J = 9.0 Hz, 4H), 6.96 (t, J = 7.2 Hz, 2H), 7.04-7.10 (m, 12H), 7.20-7.25 (m, 4H), 7.40 (d, J = 8.7 Hz, 4H).
LC/MS (ESI⁺) m/z; 813 [M+1]⁺

### [Synthesis Example 5] Synthesis of compound 5

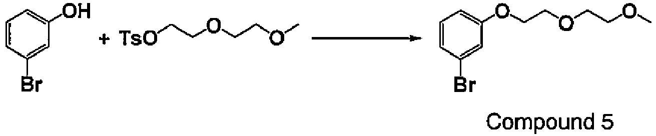

Using 1 g (5.8 mmol) of 3-bromophenol, 2.54 g (9.2 mmol) of 2-(2-methoxyethoxy)ethyl p-toluenesulfonate synthesized by the method described in Macromolecules vol. 34, 2001, p. 931, and 1.28 g (9.2 mmol) of potassium carbonate, synthesis was conducted by the same procedure as in Synthesis Example 3, to obtain 1.38 g of a colorless liquid compound 5 (yield: 87%).
¹H-NMR (300 MHz, CDCl₃):
   δ 3.39 (s, 3H), 3.56-3.59 (m, 2H), 3.70-3.74 (m, 2H), 3.85 (app t, J = 4.8 Hz, 2H), 4.12 (app t, J = 4.8 Hz, 2H), 6.84 (ddd, J = 1.5, 2.4, 7.8 Hz, 2H), 7.05-7.15 (m, 3H).
LC/MS (ESI⁺) m/z; 275, 277 [M+1]⁺

### [Synthesis Example 6] Synthesis of compound 6

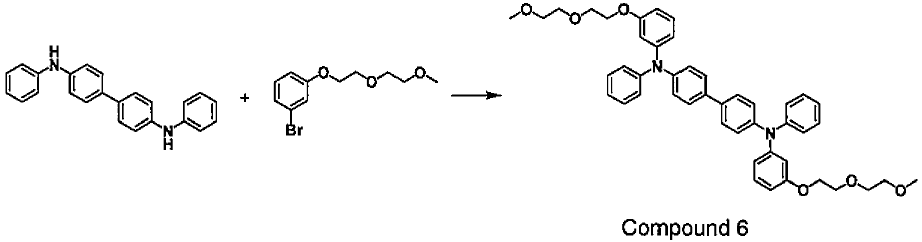

Using 703 mg (2.1 mmol) of N,N'-diphenylbenzidine, 1.38 g (5 mmol) of the compound 5 obtained in Synthesis Example 5, 121 mg (0.21 mmol) of Pd(dba)₂, 600 mg (6.3 mmol) of t-BuONa, and 100 µL (0.42 mmol) of di-t-butylphenylphosphine, synthesis was conducted by the same procedure as in Synthesis Example 2, to obtain 1.52 g of a brown liquid compound 6 (yield: 100%).
¹H-NMR (300 MHz, CDCl₃):
   δ 3.37 (s, 6H), 3.54-3.57 (m, 4H), 3.67-3.70 (m, 4H), 3.80 (app t, J = 4.8 Hz, 4H), 4.05 (app t, J = 4.5 Hz, 4H), 6.56-6.59 (m, 2H), 6.68-6.71 (m, 4H), 7.02 (app t, J = 7.2 Hz, 2H), 7.10-7.17 (m, 10H), 7.23-7.28 (m, 4H), 7.44 (d, J = 8.7 Hz, 4H).
LC/MS (ESI⁺) m/z; 725 [M+1]⁺

### [Synthesis Example 7] Synthesis of polymer 1

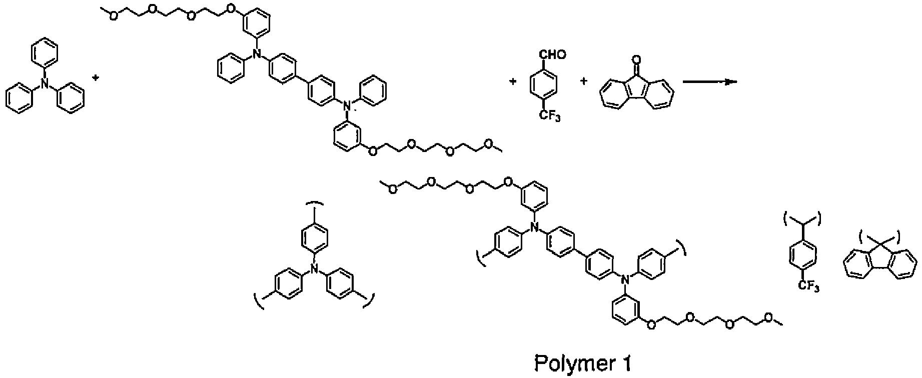

4 g of 1,4-dioxane was added to 0.96 g (3.9 mmol) of triphenylamine, 1.06 g (1.3 mmol) of the compound 2 obtained in Synthesis Example 2, 0.09 g (0.52 mmol) of 4-trifluoromethylbenzaldehyde, 0.84 g (4.68 mmol) of 9-fluorenone and 0.99 g (5.2 mmol) of p-toluenesulfonic acid monohydrate, followed by heating at reflux for eight hours and cooling to room temperature. After the cooling, the reaction mixture was diluted by addition of 12 mL of tetrahydrofuran, the admixture was added dropwise to methanol (100 mL)/28% aqueous ammonia (20 mL), followed by stirring for one hour. The precipitated powder was collected by filtration under reduced pressure, and was dissolved in 15 mL of toluene. The resulting solution was added dropwise to 120 mL of methanol, followed by stirring for one hour. The precipitated powder was collected by filtration under reduced pressure, and was vacuum dried to obtain 2.04 g of a polymer 1.
Mw (GPC) = 3,400
Mn (GPC) = 1,400
Mw/Mn = 2.4

### [Synthesis Example 8] Synthesis of polymer 2

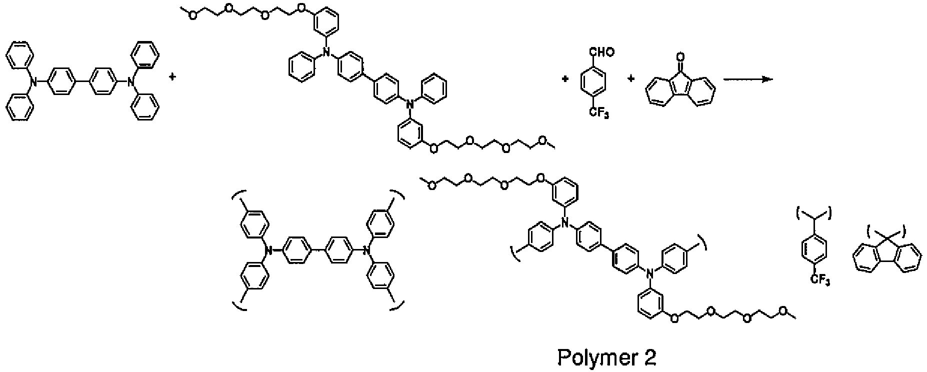

Using 1.47 g (3.0 mmol) of N,N,N',N'-tetraphenylbenzidine, 0.81 g (1.0 mmol) of the compound 2 obtained in Synthesis Example 2, 0.14 g (0.8 mmol) of 4-trifluoromethylbenzaldehyde, 1.30 g (7.2 mmol) of 9-fluorenone and 0.76 g (4.0 mmol) of p-toluenesulfonic acid monohydrate, synthesis was conducted by the same procedure as in Synthesis Example 7, to obtain 2.18 g of a polymer 2.
Mw (GPC) = 4,500
Mn (GPC) = 2,900
Mw/Mn = 1.6

### [Synthesis Example 9] Synthesis of polymer 3

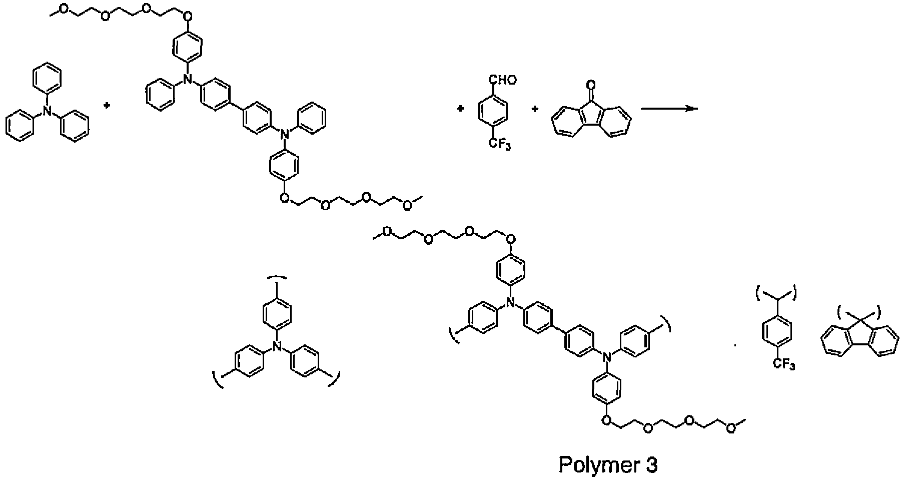

Using 0.59 g (2.4 mmol) of triphenylamine, 0.65 g (0.8 mmol) of the compound 4 obtained in Synthesis Example 4, 55.7 mg (0.32 mmol) of 4-trifluoromethylbenzaldehyde, 0.52 g (2.9 mmol) of 9-fluorenone and 0.61 g (3.2 mmol) of p-toluenesulfonic acid monohydrate, synthesis was conducted by the same procedure as in Synthesis Example 7, to obtain 1.24 g of a polymer 3.
Mw (GPC) = 3,300
Mn (GPC) = 2,200
Mw/Mn = 1.6

### [Synthesis Example 10] Synthesis of polymer 4

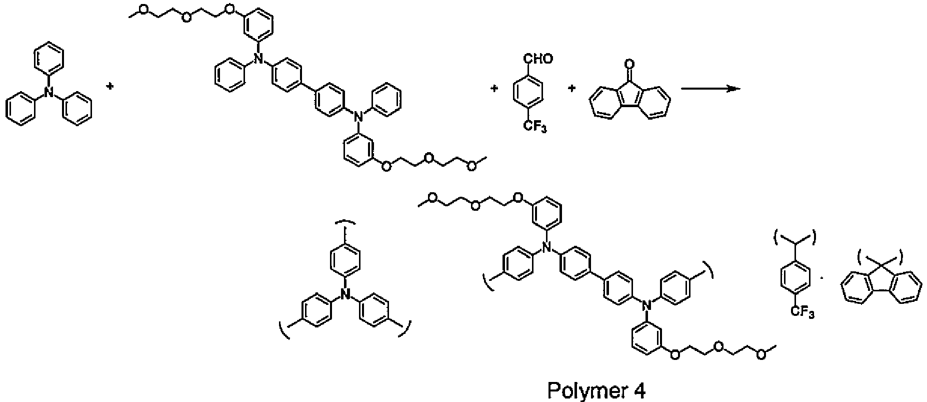

Using 0.59 g (2.4 mmol) of triphenylamine, 0.58 g (0.8 mmol) of the compound 6 obtained in Synthesis Example 6, 55.7 mg (0.32 mmol) of 4-trifluoromethylbenzaldehyde, 0.52 g (2.9 mmol) of 9-fluorenone and 0.49 g (2.6 mmol) of p-toluenesulfonic acid monohydrate, synthesis was conducted by the same procedure as in Synthesis Example 7, to obtain 1.20 g of a polymer 4.
Mw (GPC) = 4,300
Mn (GPC) = 2,200
Mw/Mn = 2.0

### [2] Preparation of Charge-transporting Varnish

### [Example 1] Charge-transporting varnish A

In a nitrogen circulation type glove box, 2.5 g of 1,3-dimethylimidazolidinone was added to a mixture of 90 mg of the polymer 1 obtained in Synthesis Example 7, 20 mg of an oligoaniline compound 1 synthesized according to the method described in WO 2013/084664 and 100 mg of phosphotungstic acid (made by Kanto Chemical Co., Inc.), followed by stirring with heating at 50°C, to effect dissolution. To the resulting solution was added 2.5 g of cyclohexanol, followed by stirring, to obtain a green solution. The solution was filtered through a syringe filter having a pore diameter of 0.2 µm, to obtain a charge-transporting varnish A.

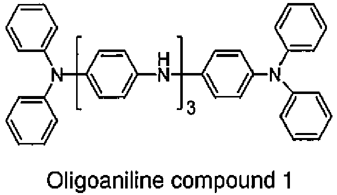

### [Example 2] Charge-transporting varnish B

A charge-transporting varnish was prepared by the same method as in Example 1, except that 90 mg of the polymer obtained in Synthesis Example 8 was used in place of the polymer 1.

### [Example 3] Charge-transporting varnish C

A charge-transporting varnish was prepared by the same method as in Example 1, except that 90 mg of the polymer 3 obtained in Synthesis Example 9 was used in place of the polymer 1.

### [Example 4] Charge-transporting varnish D

A charge-transporting varnish was prepared by the same method as in Example 1, except that 90 mg of the polymer 4 obtained in Synthesis Example 10 was used in place of the polymer 1.

### [Comparative Example 1] Charge-transporting varnish E

A charge-transporting varnish was prepared by the same method as in Example 1, except that the polymer 1 was not used and that the oligoaniline compound 1 and the phosphotungstic acid were used in amounts of 20 mg and 100 mg, respectively.

### [3] Production and Characteristics Evaluation of Organic EL Element (OLED Element)

As a substrate at the time of evaluating electrical characteristics, a 25 mm × 25 mm × 0.7 (t) glass substrate provided on its surface with a pattern of indium tin oxide in a thickness of 150 nm (hereinafter referred to simply as ITO substrate) was used. The ITO substrate was used after impurities on the surface thereof were removed by an O₂ plasma cleaning apparatus (150 W, 30 seconds).

### [Example 5] Production of OLED element by use of charge-transporting varnish A

The charge-transporting varnish A obtained in Example 1 was applied to the ITO substrate by use of a spin coater, followed by drying at 80°C for one minute and, further, baking at 230°C for 15 minutes, to form a 35 nm-thick uniform thin film on the ITO substrate.

Next, thin films of tris(8-quinolinolato)aluminum(III) (Alq₃), lithium fluoride, and aluminum were sequentially layered over the ITO substrate (having been provided thereon with the thin film) by use of a vapor deposition apparatus (vacuum degree 1.0×10⁻⁵ Pa), to obtain an OLED element. In this case, the vapor deposition rate was 0.2 nm/second for Alq₃ and aluminum, and 0.02 nm/second for lithium fluoride. The thicknesses of the thin films were 40 nm, 0.5 nm, and 100 nm, respectively.

Note that for preventing characteristics of the OLED element from being deteriorated under the influences of oxygen, and moisture in air, the OLED element was sealed by use of sealing substrates, before evaluation of the characteristics. The sealing was conducted according to the following procedure.

In a nitrogen atmosphere having an oxygen concentration of up to 2 ppm and a dew point of up to -85°C, the organic EL element was placed between the sealing substrates, and the sealing substrates were laminated together using an adhesive (MORESCO MOITURE CUT WB90US(P), made by Moresco Corporation). In this case, a desiccant (HD-071010W-40, made by Dynic Corporation) was placed together with the OLED element inside the sealing substrates.

The adhesive was cured by irradiating the laminated sealing substrates with UV light (wavelength: 365 nm, dosage: 6,000 mJ/cm²), and annealing at 80°C for one hour.

### [Example 6] Production of OLED element by use of charge-transporting varnish B

An OLED element was produced by the same method as in Example 5, except that the charge-transporting varnish B obtained in Example 2 was used in place of the charge-transporting varnish A.

### [Example 7] Production of OLED element by use of charge-transporting varnish C

An OLED element was produced by the same method as in Example 5, except that the charge-transporting varnish C obtained in Example 3 was used in place of the charge-transporting varnish A.

### [Example 8] Production of OLED element by use of charge-transporting varnish D

An OLED element was produced by the same method as in Example 5, except that the charge-transporting varnish D obtained in Example 4 was used in place of the charge-transporting varnish A.

### [Comparative Example 2]

### Production of OLED element by use of charge-transporting varnish E

An OLED element was produced by the same method as in Example 5, except that the charge-transporting varnish E obtained in Comparative Example 1 was used in place of the charge-transporting varnish A.

The OLED elements obtained in Examples 5 to 8 and Comparative Example 2 were put to measurements of electrical characteristics. Current density, luminance and current efficiency at a driving voltage of 7 V are set forth in Table 1.

**[Table 1]**

| | Current density (mA/cm²) | Luminance (cd/m²) | Current efficiency (cd/A) |
|---|---|---|---|
| Example 5 | 798 | 15,100 | 1.9 |
| Example 6 | 306 | 5,625 | 1.9 |
| Example 7 | 491 | 4,365 | 0.9 |
| Example 8 | 263 | 4,900 | 1.9 |
| Comparative Example 2 | 3,425 | 611 | 0.0 |

As depicted in Table 1, it was seen that in Comparative Example 2 wherein the charge-transporting varnish E containing none of the polymers 1 to 4 added thereto was used, the current density was conspicuously low, and the luminance was low as compared to the current density.

Thus, it is seen that by addition of any one of the polymers 1 to 4 to the charge-transporting varnish, it is possible to enhance the current efficiency and luminance of the OLED element obtained.

## Claims

1. A charge-transporting varnish comprising: a fluorine-containing charge-transporting substance; a non-fluorine-containing charge-transporting substance; a dopant substance composed of a heteropoly-acid; and an organic solvent,
wherein the fluorine-containing charge-transporting substance is a polymer which has a weight average molecular weight measured by gel permeation chromatography of 500 to 200,000 and which is obtainable by condensing: at least one compound selected from triarylamine compounds and N,N,N',N'-tetraarylbenzidine compounds; an N,N,N',N'-tetraarylbenzidine compound having at least one aryl group substituted with an alkoxy group which may include an ether linkage; a fluorine-containing aryl aldehyde compound; and a fluorene derivative having a carbonyl group, and
the non-fluorine-containing charge-transporting substance is an oligoaniline compound.

2. The charge-transporting varnish according to claim 1, wherein the fluorine-containing charge-transporting substance is a polymer obtainable by condensing: at least one compound selected from triarylamine compounds represented by formula (1) and N,N,N',N'-tetraarylbenzidine compounds represented by formula (2); an N,N,N',N'-tetraarylbenzidine compound represented by formula (3); a fluorine-containing aryl aldehyde compound represented by formula (4); and a fluorene derivative having a carbonyl group that is represented by formula (5) or formula (6): 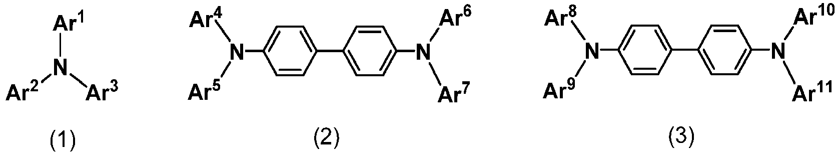 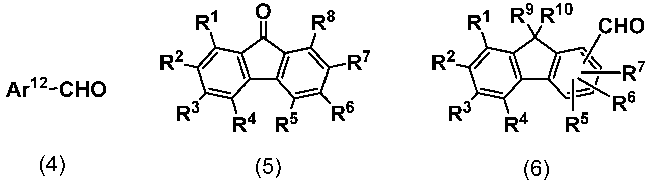
wherein Ar¹ to Ar⁷ each independently represent an aryl group which has 6 to 20 carbon atoms and may be substituted with Z¹, provided that at least one of ring-forming carbon atoms in each of Ar¹ to Ar³ is unsubstituted, and at least one of ring-forming carbon atoms in each of Ar⁴ to Ar⁷ is unsubstituted,
Ar⁸ to Ar¹¹ each independently represent an aryl group which has 6 to 20 carbon atoms and may be substituted with Z², provided that at least one of ring-forming carbon atoms in at least two of Ar⁸ to Ar¹¹ is unsubstituted, and at least one of Ar⁸ to Ar¹¹ is substituted with Z²,
Ar¹² represents an aryl group which has 6 to 20 carbon atoms and is substituted with at least one Z³ and which may be substituted with Z⁴,
R¹ to R⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
R⁹ and R¹⁰ each independently represent a hydrogen atom, an alkyl group having 1 to 20 carbon atoms, (poly)ethylene oxide group having 2 to 20 carbon atoms, alkenyl group having 2 to 20 carbon atoms or alkynyl group having 2 to 20 carbon atoms which may be substituted with Z⁵, or an alkyl group which has 1 to 20 carbon atoms and is substituted with an ethenyl group or an ethynyl group and which may be substituted with Z⁵,
Z¹ represents a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
Z² represents an alkoxy group which has 1 to 20 carbon atoms and may include an ether linkage,
Z³ represents a fluorine atom, a fluorinated alkyl group having 1 to 20 carbon atoms, or a fluorinated aryl group having 6 to 20 carbon atoms,
Z⁴ represents a chlorine atom, a bromine atom, an iodine atom, a nitro group, a cyano group, or an alkyl group having 1 to 20 carbon atoms, alkenyl group having 2 to 20 carbon atoms or alkynyl group having 2 to 20 carbon atoms which may be substituted with Z⁶,
Z⁵ represents a halogen atom, a nitro group, or a cyano group, and
Z⁶ represents a chlorine atom, a bromine atom, an iodine atom, a nitro group, or a cyano group.

3. The charge-transporting varnish according to claim 2, wherein the triarylamine compound is a triphenylamine derivative represented by formula (7): 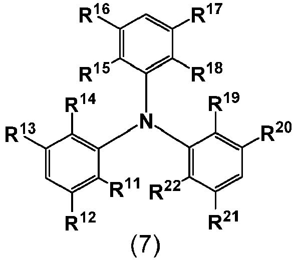
wherein R¹¹ to R²² each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
wherein Z⁵ is as defined in claim 2.

4. The charge-transporting varnish according to claim 2, wherein the N,N,N',N'-tetraarylbenzidine compound represented by the formula (2) is represented by formula (8) : 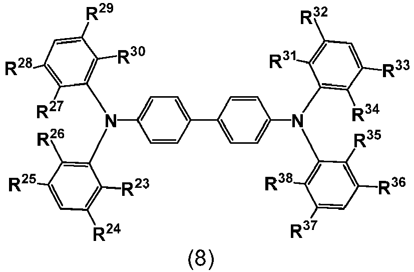
wherein R²³ to R³⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
wherein Z⁵ is as defined in claim 2.

5. The charge-transporting varnish according to claim 2, wherein the N,N,N',N'-tetraarylbenzidine compound represented by the formula (3) is represented by formula (9-1) : 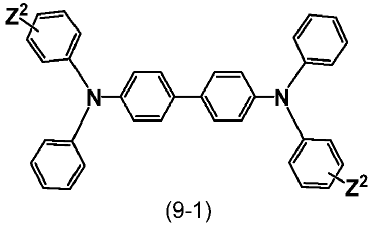 wherein Z² is as defined in claim 2.

6. The charge-transporting varnish according to claim 5, wherein the N,N,N',N'-tetraarylbenzidine compound represented by the formula (3) is represented by formula (9-2) : 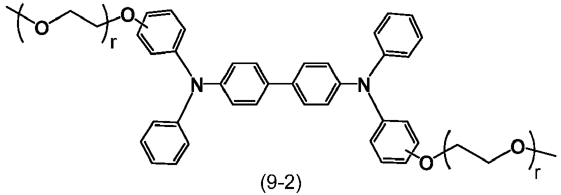 wherein letters r each represent an integer of 1 to 10.

7. The charge-transporting varnish according to claim 6, wherein the N,N,N',N'-tetraarylbenzidine compound represented by the formula (3) is represented by any one of formulas (10-1) to (10-8).

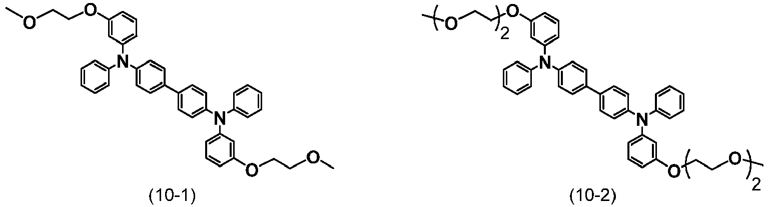

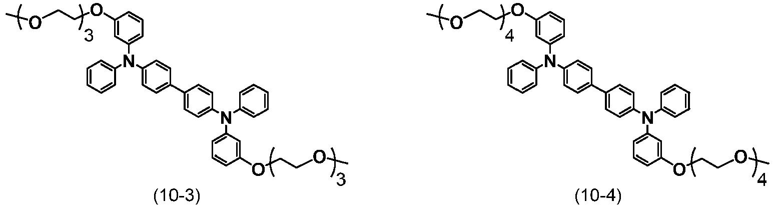

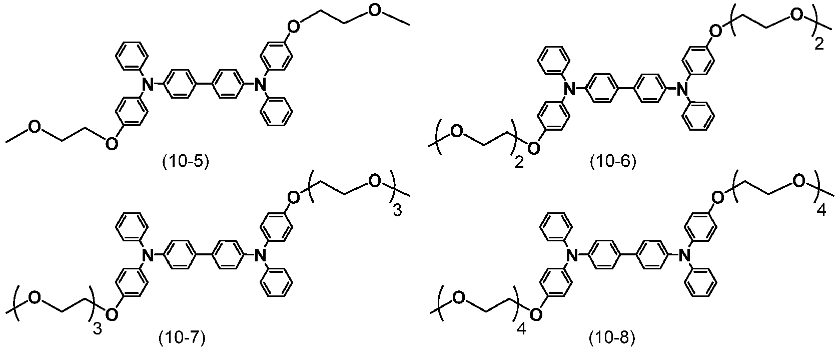

8. The charge-transporting varnish according to claim 7, wherein the N,N,N',N'-tetraarylbenzidine compound represented by the formula (3) is represented by the formula (10-7).

9. The charge-transporting varnish according to any one of claims 2 to 8, wherein the aryl aldehyde compound is represented by formula (11) or formula (12): 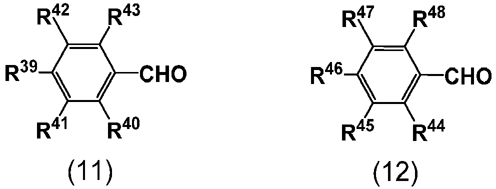
wherein R³⁹ represents a fluorine atom or a fluorinated alkyl group having 1 to 20 carbon atoms,
R⁴⁰ to R⁴³ each independently represent a hydrogen atom, a nitro group, a cyano group, or an alkyl group which has 1 to 20 carbon atoms and may be substituted with a nitro group or a cyano group, and
R⁴⁴ to R⁴⁸ each independently represent a fluorine atom or a fluorinated alkyl group having 1 to 20 carbon atoms.

10. The charge-transporting varnish according to any one of claims 1 to 9, wherein the oligoaniline compound is represented by formula (13); 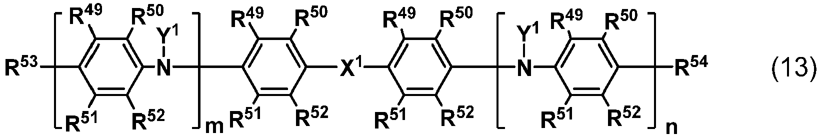
wherein R⁴⁹ to R⁵⁴ each independently represent a hydrogen atom, a halogen atom (exclusive of a fluorine atom), a nitro group, a cyano group, an alkyl group having 1 to 20 carbon atoms, alkenyl group having 2 to 20 carbon atoms or alkynyl group having 2 to 20 carbon atoms which may be substituted with Z⁷, an aryl group having 6 to 20 carbon atoms or heteroaryl group having 2 to 20 carbon atoms which may be substituted with Z⁸, a-NHY², -NY³Y⁴, -C(O)Y⁵, -OY⁶, -SY⁷, -SO₃Y⁸, -C(O)OY⁹,-OC(O)Y¹⁰, -C(O)NHY¹¹, or -C(O)NY¹²Y¹³ group,
Y² to Y¹³ each independently represent an alkyl group having 1 to 20 carbon atoms, alkenyl group having 2 to 20 carbon atoms or alkynyl group having 2 to 20 carbon atoms which may be substituted with Z⁷, or an aryl group having 6 to 20 carbon atoms or heteroaryl group having 2 to 20 carbon atoms which may be substituted with Z⁸,
X¹ represents -NY¹-, -O-, -S-, -(CR⁵⁵R⁵⁶)ₗ- or a single bond, where R⁵⁵ and R⁵⁶ have the same meaning as the R⁴⁹,
letter 1 is an integer of 1 to 20,
Y¹ each independently represents a hydrogen atom, an alkyl group having 1 to 20 carbon atoms, alkenyl group having 2 to 20 carbon atoms or alkynyl group having 2 to 20 carbon atoms which may be substituted with Z⁷, or an aryl group having 6 to 20 carbon atoms or heteroaryl group having 2 to 20 carbon atoms which may be substituted with Z⁸,
Z⁷ represents a halogen atom (exclusive of a fluorine atom), a nitro group, a cyano group, or an aryl group having 6 to 20 carbon atoms or heteroaryl group having 2 to 20 carbon atoms which may be substituted with Z⁹,
Z⁸ represents a halogen atom (exclusive of a fluorine atom), a nitro group, a cyano group, or an alkyl group having 1 to 20 carbon atoms, alkenyl group having 2 to 20 carbon atoms or alkynyl group having 2 to 20 carbon atoms which may be substituted with Z⁹,
Z⁹ represents a halogen atom (exclusive of a fluorine atom), a nitro group or a cyano group, and
letters m and n are each independently an integer of 1 to 10, satisfying m+n ≤ 10.

11. The charge-transporting varnish according to any one of claims 1 to 10, wherein the heteropoly-acid is phosphotungstic acid.

12. A charge-transporting thin film obtainable by use of the charge-transporting varnish according to any one of claims 1 to 11.

13. An organic electroluminescent element comprising the charge-transporting thin film according to claim 12.

14. An organic electroluminescent element comprising at least an anode, a cathode, a light-emitting layer, and the charge-transporting thin film according to claim 12,
wherein the charge-transporting thin film is provided between, and in contact with, the anode and the light-emitting layer.

15. A method of producing a charge-transporting thin film, **characterized by** applying the charge-transporting varnish according to any one of claims 1 to 11 onto a substrate, and evaporating the solvent.

16. A method of producing an organic electroluminescent element, wherein the charge-transporting thin film according to claim 12 is used.

17. A polymer which has a weight average molecular weight measured by gel permeation chromatography of 500 to 200,000 and which is obtainable by condensing: at least one compound selected from triarylamine compounds represented by formula (1) and N,N,N',N'-tetraarylbenzidine compounds represented by formula (2); an N,N,N',N'-tetraarylbenzidine compound represented by formula (3); a fluorine-containing aryl aldehyde compound represented by formula (4); and a fluorene derivative having a carbonyl group that is represented by formula (5) or formula (6); and 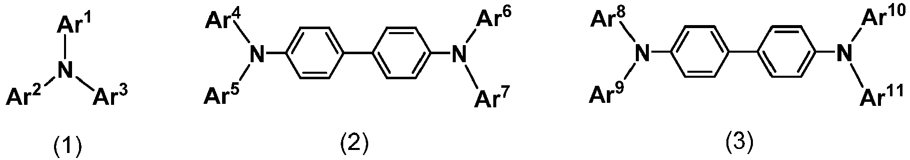 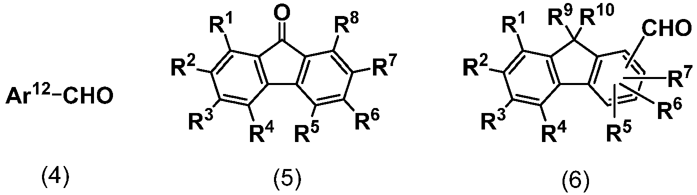
wherein Ar¹ to Ar⁷ each independently represent an aryl group which has 6 to 20 carbon atoms and may be substituted with Z¹, provided that at least one of ring-forming carbon atoms in each of Ar¹ to Ar³ is unsubstituted, and at least one of ring-forming carbon atoms in each of Ar⁴ to Ar⁷ is unsubstituted,
Ar⁸ to Ar¹¹ each independently represent an aryl group which has 6 to 20 carbon atoms and may be substituted with Z², provided that at least one of ring-forming carbon atoms in at least two of Ar⁸ to Ar¹¹ is unsubstituted, and at least one of Ar⁸ to Ar¹¹ is substituted with Z²,
Ar¹² represents an aryl group which has 6 to 20 carbon atoms and is substituted with at least one Z³ and which may be substituted with Z⁴,
R¹ to R⁸ each independently represent a hydrogen atom, a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
R⁹ and R¹⁰ each independently represent a hydrogen atom, an alkyl group having 1 to 20 carbon atoms, (poly)ethylene oxide group having 2 to 20 carbon atoms, alkenyl group having 2 to 20 carbon atoms or alkynyl group having 2 to 20 carbon atoms which may be substituted with Z⁵, or an alkyl group which has 1 to 20 carbon atoms and is substituted with an ethenyl group or an ethynyl group and which may be substituted with Z⁵,
Z¹ represents a halogen atom, a nitro group, a cyano group, or an alkyl group having 1 to 20 carbon atoms, alkenyl group having 2 to 20 carbon atoms or alkynyl group having 2 to 20 carbon atoms which may be substituted with Z⁵,
Z² represents an alkoxy group which has 1 to 20 carbon atoms and may include an ether linkage,
Z³ represents a fluorine atom, a fluorinated alkyl group having 1 to 20 carbon atoms, or a fluorinated aryl group having 6 to 20 carbon atoms,
Z⁴ represents a chlorine atom, a bromine atom, an iodine atom, a nitro group, a cyano group, or an alkyl group having 1 to 20 carbon atoms, alkenyl group having 2 to 20 carbon atoms or alkynyl group having 2 to 20 carbon atoms which may be substituted with Z⁶,
Z⁵ represents a halogen atom, a nitro group, or a cyano group, and
Z⁶ represents a chlorine atom, a bromine atom, an iodine atom, a nitro group, or a cyano group.

## Patentansprüche

1. Ladungstransportlack, der Folgendes umfasst: eine Fluor enthaltende Ladungstransportsubstanz; eine Fluor nicht enthaltende Ladungstransportsubstanz; eine aus einer Heteropolysäure bestehende Dotierungssubstanz und ein organisches Lösungsmittel,
wobei die Fluor enthaltende Ladungstransportsubstanz ein Polymer ist, dessen gewichtsmittleres Molekulargewicht, gemessen mittels Gel-Permeationschromatographie, 500 bis 200.000 beträgt und das erhältlich ist mittels Kondensation von: zumindest einer aus Triarylamin-Verbindungen und N,N,N',N'-Tetraarylbenzidin-Verbindungen ausgewählten Verbindung; einer N,N,N',N'-Tetraarylbenzidin-Verbindung mit zumindest einer Arylgruppe, die mit einer gegebenenfalls eine Etherbindung umfassenden Alkoxygruppe substituiert ist; einer Fluor enthaltenden Arylaldehyd-Verbindung; und einem Fluoren-Derivat mit einer Carbonylgruppe; und
wobei die Fluor nicht enthaltende Ladungstransportsubstanz eine Oligoanilin-Verbindung ist.

2. Ladungstransportlack nach Anspruch 1, wobei die Fluor enthaltende Ladungstransportsubstanz ein Polymer ist, das erhältlich ist mittels Kondensation von: zumindest einer aus durch Formel (1) dargestellten Triarylamin-Verbindungen und durch Formel (2) dargestellten N,N,N',N'-Tetraarylbenzidin-Verbindungen ausgewählten Verbindung; einer durch Formel (3) dargestellten N,N,N',N'-Tetraarylbenzidin-Verbindung; einer durch Formel (4) dargestellten Fluor enthaltenden Arylaldehyd-Verbindung; und einem durch Formel (5) oder Formel (6) dargestellten Fluoren-Derivat mit einer Carbonylgruppe: 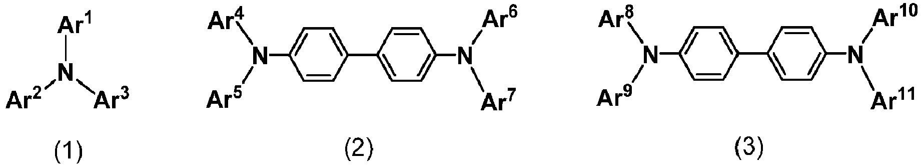 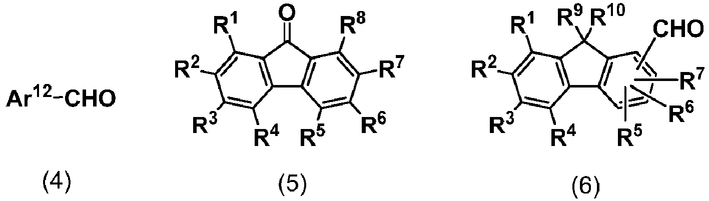
worin Ar¹ bis Ar⁷ jeweils unabhängig für eine Arylgruppe mit 6 bis 20 Kohlenstoffatomen stehen und gegebenenfalls mit Z¹ substituiert sind, mit der Maßgabe, dass jeweils zumindest eines der ringbildenden Kohlenstoffatome in Ar¹ bis Ar³ unsubstituiert ist und jeweils zumindest eines der ringbildenden Kohlenstoffatome in Ar⁴ bis Ar⁷ unsubstituiert ist,
Ar⁸ bis Ar¹¹ jeweils unabhängig für eine Arylgruppe mit 6 bis 20 Kohlenstoffatomen stehen und gegebenenfalls mit Z² substituiert sind, mit der Maßgabe, dass zumindest eines der ringbildenden Kohlenstoffatome in zumindest zwei von Ar⁸ bis Ar¹¹ unsubstituiert ist und zumindest eines von Ar⁸ bis Ar¹¹ mit Z² substituiert ist,
Ar¹² für eine Arylgruppe mit 6 bis 20 Kohlenstoffatomen steht und mit zumindest einem Z³ substituiert ist und gegebenenfalls mit Z⁴ substituiert ist,
R¹ bis R⁸ jeweils unabhängig für ein Wasserstoffatom, ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, stehen,
R⁹ und R¹⁰ jeweils unabhängig für ein Wasserstoffatom, eine Alkylgruppe mit 1 bis 20 Kohlenstoffatomen, eine (Poly-)Ethylenoxidgruppe mit 2 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, oder eine Alkylgruppe mit 1 bis 20 Kohlenstoffatomen, die mit einer Ethenylgruppe oder einer Ethinylgruppe substituiert ist und gegebenenfalls mit Z⁵ substituiert ist, stehen,
Z¹ für ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, steht,
Z² für eine Alkoxygruppe mit 1 bis 20 Kohlenstoffatomen steht und gegebenenfalls eine Etherbindung umfasst,
Z³ für ein Fluoratom, eine fluorierte Alkylgruppe mit 1 bis 20 Kohlenstoffatomen oder eine fluorierte Arylgruppe mit 6 bis 20 Kohlenstoffatomen steht,
Z⁴ für ein Chloratom, ein Bromatom, ein lodatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁶ substituiert sind, steht,
Z⁵ für ein Halogenatom, eine Nitrogruppe oder eine Cyanogruppe steht und
Z⁶ für ein Chloratom, ein Bromatom, ein lodatom, eine Nitrogruppe oder eine Cyanogruppe steht.

3. Ladungstransportlack nach Anspruch 2, wobei die Triarylamin-Verbindung ein durch Formel (7) dargestelltes Triphenylamin-Derivat ist: 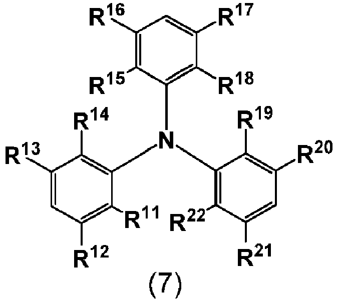
worin R¹¹ bis R²² jeweils unabhängig für ein Wasserstoffatom, ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, stehen,
worin Z⁵ wie in Anspruch 2 definiert ist.

4. Ladungstransportlack nach Anspruch 2, wobei die durch die Formel (2) dargestellte N,N,N',N'-Tetraarylbenzidin-Verbindung durch Formel (8) dargestellt ist: 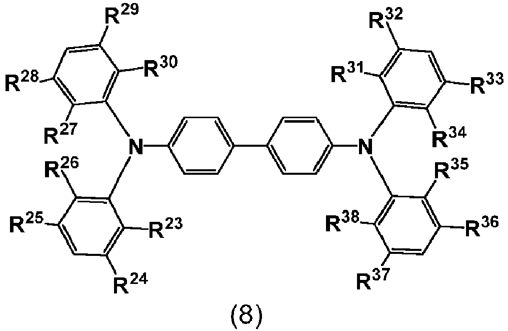
worin R²³ bis R³⁸ jeweils unabhängig für ein Wasserstoffatom, ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, stehen,
worin Z⁵ wie in Anspruch 2 definiert ist.

5. Ladungstransportlack nach Anspruch 2, wobei die durch Formel (3) dargestellte N,N,N',N'-Tetraarylbenzidin-Verbindung durch Formel (9-1) dargestellt ist: 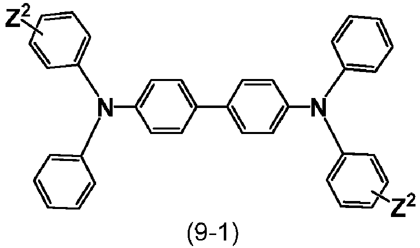 worin Z² wie in Anspruch 2 definiert ist.

6. Ladungstransportlack nach Anspruch 5, wobei die durch Formel (3) dargestellte N,N,N',N'-Tetraarylbenzidin-Verbindung durch Formel (9-2) dargestellt ist: 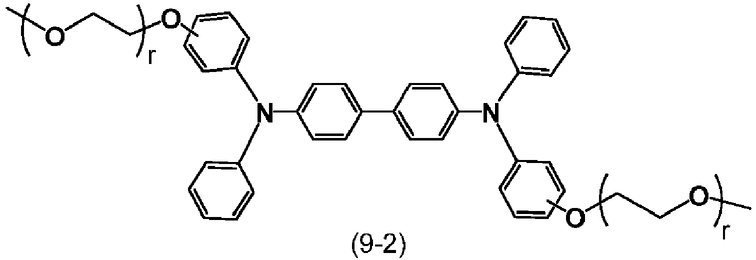 worin die Buchstaben r jeweils für eine ganze Zahl von 1 bis 10 stehen.

7. Ladungstransportlack nach Anspruch 6, wobei die durch Formel (3) dargestellte N,N,N',N'-Tetraarylbenzidin-Verbindung durch eine beliebige der Formeln (10-1) bis (10-8) dargestellt ist:

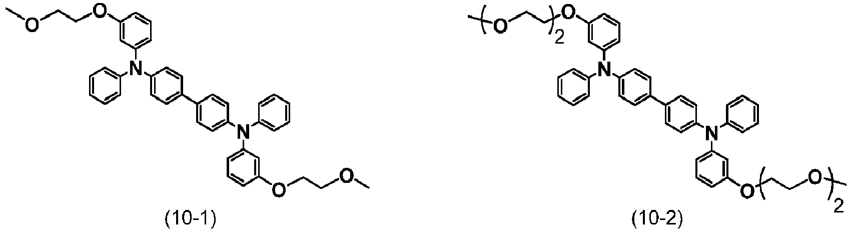

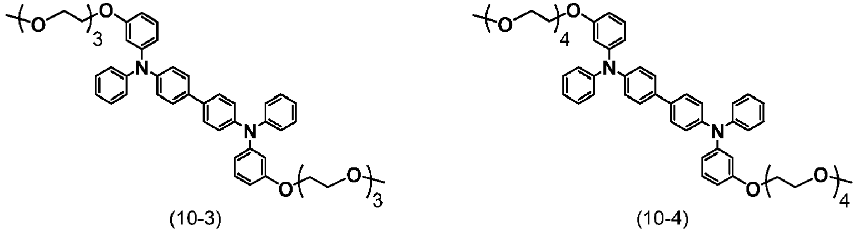

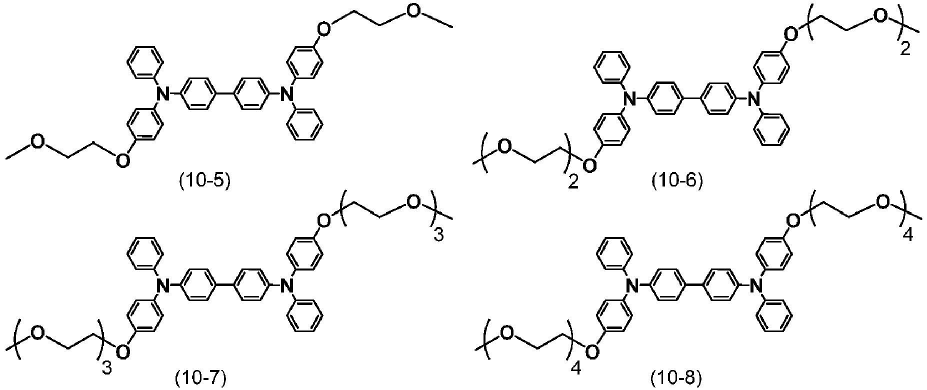

8. Ladungstransportlack nach Anspruch 7, wobei die durch Formel (3) dargestellte N,N,N',N'-Tetraarylbenzidin-Verbindung durch Formel (10-7) dargestellt ist.

9. Ladungstransportlack nach einem der Ansprüche 2 bis 8, wobei die Arylaldehyd-Verbindung durch Formel (11) oder Formel (12) dargestellt ist: 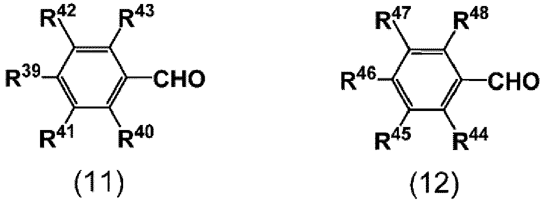
worin R²⁹ für ein Fluoratom oder eine fluorierte Alkylgruppe mit 1 bis 20 Kohlenstoffatomen steht,
R⁴⁰ bis R⁴² jeweils unabhängig für ein Wasserstoffatom, eine Nitrogruppe, eine Cyanogruppe oder eine Alkylgruppe mit 1 bis 20 Kohlenstoffatomen stehen und gegebenenfalls mit einer Nitrogruppe oder einer Cyanogruppe substituiert sind und
R⁴⁴ bis R⁴⁸ jeweils unabhängig für ein Fluoratom oder eine fluorierte Alkylgruppe mit 1 bis 20 Kohlenstoffatomen stehen.

10. Ladungstransportlack nach einem der Ansprüche 1 bis 9, wobei die Oligoanilin-Verbindung durch Formel (13) dargestellt ist: 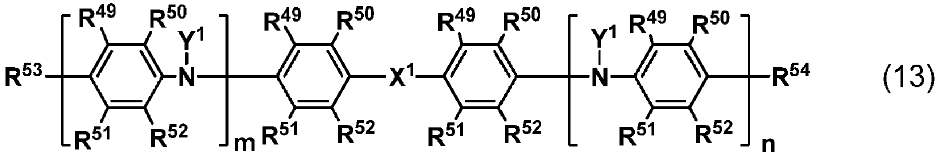
worin R⁴⁹ bis R⁵⁴ jeweils unabhängig für ein Wasserstoffatom, ein Halogenatom (mit Ausnahme eines Fluoratoms), eine Nitrogruppe, eine Cyanogruppe, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁷ substituiert sind, eine Arylgruppe mit 6 bis 20 Kohlenstoffatomen oder eine Heteroarylgruppe mit 2 bis 20 Kohlenstoffatomen, die gegebenenfalls mit Z⁸, einer -NHY²-, -NY³Y⁴-, -C(O)Y⁵-, -OY⁶-, -SY⁷-, -SO₃Y⁸-, -C(O)OY⁹-, -OC(O)Y¹⁰-, -C(O)NHY¹¹- oder -C(O)NY¹²Y¹³-Gruppe substituiert sind, stehen,
Y² bis Y¹³ jeweils unabhängig für eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁷ substituiert sind, oder eine Arylgruppe mit 6 bis 20 Kohlenstoffatomen oder eine Heteroarylgruppe mit 2 bis 20 Kohlenstoffatomen, die gegebenenfalls mit Z⁸ substituiert sind, stehen,
X¹ für -NY¹-, -O-, -S-, -(CR⁵⁵R⁵⁶)ₗ- oder eine Einfachbindung steht, wobei R⁵⁵ und R⁵⁶ dieselbe Bedeutung haben wie R⁴⁹,
der Buchstabe I für eine ganze Zahl von 1 bis 20 steht,
Y¹ jeweils unabhängig für ein Wasserstoffatom, eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁷ substituiert sind, oder eine Arylgruppe mit 6 bis 20 Kohlenstoffatomen oder eine Heteroarylgruppe mit 2 bis 20 Kohlenstoffatomen, die mit gegebenenfalls Z⁸ substituiert sind, steht,
Z⁷ für ein Halogenatom (mit Ausnahme eines Fluoratoms), eine Nitrogruppe, eine Cyanogruppe oder eine Arylgruppe mit 6 bis 20 Kohlenstoffatomen oder eine Heteroarylgruppe mit 2 bis 20 Kohlenstoffatomen, die gegebenenfalls mit Z⁹ substituiert sind, steht,
Z⁸ für ein Halogenatom (mit Ausnahme eines Fluoratoms), eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁹ substituiert sind, steht,
Z⁹ für ein Halogenatom (mit Ausnahme eines Fluoratoms), eine Nitrogruppe oder eine Cyanogruppe steht und
die Buchstaben m und n jeweils unabhängig für eine ganze Zahl von 1 bis 10 stehen, für die gilt: m+n ≤ 10.

11. Ladungstransportlack nach einem der Ansprüche 1 bis 10, wobei die Heteropolysäure Phosphorwolframsäure ist.

12. Ladungstransportdünnfilm, der unter Verwendung eines Ladungstransportlacks nach einem der Ansprüche 1 bis 11 erhältlich ist.

13. Organisches elektrolumineszierendes Element, das einen Ladungstransportdünnfilm nach Anspruch 12 umfasst.

14. Organisches elektrolumineszierendes Element, das zumindest eine Anode, eine Kathode, eine lichtemittierende Schicht und einen Ladungstransportdünnfilm nach Anspruch 12 umfasst,
wobei der Ladungstransportdünnfilm zwischen der Anode und der lichtemittierenden Schicht und in Kontakt mit diesen bereitgestellt ist.

15. Verfahren zur Herstellung eines Ladungstransportdünnfilms, **dadurch gekennzeichnet, dass** ein Ladungstransportlack nach einem der Ansprüche 1 bis 11 auf ein Substrat aufgebracht wird und das Lösungsmittel abgedampft wird.

16. Verfahren zur Herstellung eines organischen elektrolumineszierenden Elements, bei dem ein Ladungstransportdünnfilm nach Anspruch 12 verwendet wird.

17. Polymer mit einem gewichtsmittleren Molekulargewicht, gemessen mittels GelPermeationschromatographie, von 500 bis 200.000, das erhältlich ist mittels Kondensation von: zumindest einer aus durch Formel (1) dargestellten Triarylamin-Verbindungen und durch Formel (2) dargestellten N,N,N',N'-Tetraarylbenzidin-Verbindungen ausgewählter Verbindung; einer durch Formel (3) dargestellten N,N,N',N'-Tetraarylbenzidin-Verbindung; einer durch Formel (4) dargestellten, Fluor enthaltenden Arylaldehyd-Verbindung; und einem durch Formel (5) oder Formel (6) dargestellten Fluoren-Derivat mit einer Carbonylgruppe; und 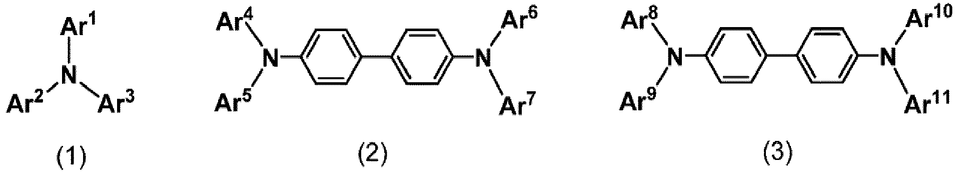 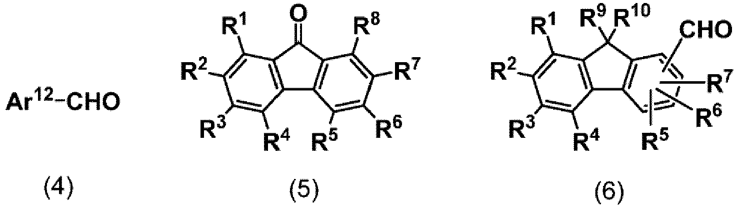
worin Ar¹ bis Ar⁷ jeweils unabhängig für eine Arylgruppe mit 6 bis 20 Kohlenstoffatomen stehen und gegebenenfalls mit Z¹ substituiert sind, mit der Maßgabe, dass jeweils zumindest eines der ringbildenden Kohlenstoffatome in Ar¹ bis Ar³ unsubstituiert ist und jeweils zumindest eines der ringbildenden Kohlenstoffatome in Ar⁴ bis Ar⁷ unsubstituiert ist,
die Ar⁸ bis Ar¹¹ jeweils unabhängig für eine Arylgruppe mit 6 bis 20 Kohlenstoffatomen stehen und gegebenenfalls mit Z² substituiert sind, mit der Maßgabe, dass zumindest eines der ringbildenden Kohlenstoffatome in zumindest zwei von Ar⁸ bis Ar¹¹ unsubstituiert ist und zumindest eines von Ar⁸ bis Ar¹¹ mit Z² substituiert ist,
Ar¹² für eine Arylgruppe mit 6 bis 20 Kohlenstoffatomen steht und mit zumindest einem Z³ substituiert ist und gegebenenfalls mit Z⁴ substituiert ist,
R¹ bis R⁸ jeweils unabhängig für ein Wasserstoffatom, ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, stehen,
R⁹ und R¹⁰ jeweils unabhängig für ein Wasserstoffatom, eine Alkylgruppe mit 1 bis 20 Kohlenstoffatomen, eine (Poly-)Ethylenoxidgruppe mit 2 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, oder eine Alkylgruppe mit 1 bis 20 Kohlenstoffatomen, die mit einer Ethenylgruppe oder einer Ethinylgruppe substituiert ist und gegebenenfalls mit Z⁵ substituiert ist, stehen,
Z¹ für ein Halogenatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁵ substituiert sind, steht,
Z² für eine Alkoxygruppe mit 1 bis 20 Kohlenstoffatomen steht und gegebenenfalls eine Etherbindung umfasst,
Z³ für ein Fluoratom, eine fluorierte Alkylgruppe mit 1 bis 20 Kohlenstoffatomen oder eine fluorierte Arylgruppe mit 6 bis 20 Kohlenstoffatomen steht,
Z⁴ für ein Chloratom, ein Bromatom, ein lodatom, eine Nitrogruppe, eine Cyanogruppe oder eine Alkylgruppe mit 1 bis 20 Kohlenstoffatomen, eine Alkenylgruppe mit 2 bis 20 Kohlenstoffatomen oder eine Alkinylgruppe mit 2 bis 20 Kohlenstoffatomen, die gegebenenfalls mit Z⁶ substituiert sind, steht,
Z⁵ für ein Halogenatom, eine Nitrogruppe oder eine Cyanogruppe steht und
Z⁶ für ein Chloratom, ein Bromatom, ein lodatom, eine Nitrogruppe oder eine Cyanogruppe steht.

## Revendications

1. Vernis de transport de charges comprenant : une substance de transport de charges fluorée ; une substance de transport de charges non fluorée ; une substance dopante composée d'un hétéropolyacide ; et un solvant organique, dans lequel la substance de transport de charges fluorée est un polymère qui a une masse moléculaire moyenne en masse, mesurée par chromatographie d'exclusion diffusion, de 500 à 200 000, et qui peut être obtenu par condensation : d'au moins un composé choisi parmi les composés triarylamines et les composés N,N,N',N'-tétraarylbenzidines ; d'un composé N,N,N',N'-tétraarylbenzidine ayant au moins un groupe aryle substitué par un groupe alcoxy qui peut contenir une liaison éther ; d'un composé arylaldéhyde fluoré ; et d'un dérivé de fluorène ayant un groupe carbonyle, et
la substance de transport de charges non fluorée est un composé oligoaniline.

2. Vernis de transport de charges selon la revendication 1, dans lequel la substance de transport de charges fluorée est un polymère pouvant être obtenu par condensation : d'au moins un composé choisi parmi les composés triarylamines représentés par la formule (1) et les composés N,N,N',N'-tétraarylbenzidines représentés par la formule (2) ; d'un composé N,N,N',N'-tétraarylbenzidine représenté par la formule (3) ; d'un composé arylaldéhyde fluoré représenté par la formule (4) ; et d'un dérivé de fluorène ayant un groupe carbonyle qui est représenté par la formule (5) ou la formule (6) : 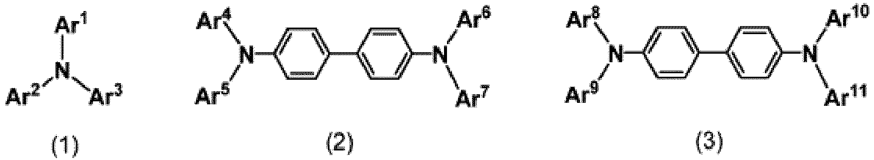 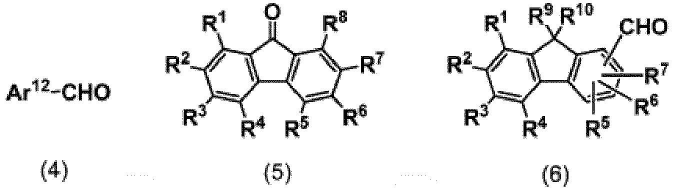
formules dans lesquelles chacun de Ar¹ à Ar⁷ représente indépendamment un groupe aryle qui a 6 à 20 atomes de carbone et qui peut être substitué par Z¹, sous réserve qu'au moins l'un des atomes de carbone formant un cycle dans chacun de Ar¹ à Ar³ soit non substitué, et qu'au moins l'un des atomes de carbone formant un cycle dans chacun de Ar⁴ à Ar⁷ soit non substitué,
chacun de Ar⁸ à Ar¹¹ représente indépendamment un groupe aryle qui a 6 à 20 atomes de carbone et qui peut être substitué par Z², sous réserve qu'au moins l'un des atomes de carbone formant un cycle dans au moins deux parmi Ar⁸ à Ar¹¹ soit non substitué, et qu'au moins l'un parmi Ar⁸ à Ar¹¹ soit substitué par Z²,
Ar¹² représente un groupe aryle qui a 6 à 20 atomes de carbone et qui est substitué par au moins un Z³ et qui peut être substitué par Z⁴,
chacun de R¹ à R⁸ représente indépendamment un atome d'hydrogène, un atome d'halogène, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁵,
chacun de R⁹ et R¹⁰ représente indépendamment un atome d'hydrogène, un groupe alkyle ayant 1 à 20 atomes de carbone, un groupe (poly)oxyde d'éthylène ayant 2 à 20 atomes de carbone, un groupe alcényle ayant 2 à 20 atomes de carbone ou un groupe alcynyle ayant 2 à 20 atomes de carbone qui peut être substitué par Z⁵, ou un groupe alkyle qui a 1 à 20 atomes de carbone et qui est substitué par un groupe éthényle ou un groupe éthynyle et qui peut être substitué par Z⁵,
Z¹ représente un atome d'halogène, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁵,
Z² représente un groupe alcoxy qui a 1 à 20 atomes de carbone et qui peut contenir une liaison éther,
Z³ représente un atome de fluor, un groupe fluoroalkyle ayant 1 à 20 atomes de carbone ou un groupe fluoroaryle ayant 6 à 20 atomes de carbone,
Z⁴ représente un atome de chlore, un atome de brome, un atome d'iode, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁶,
Z⁵ représente un atome d'halogène, un groupe nitro ou un groupe cyano, et
Z⁶ représente un atome de chlore, un atome de brome, un atome d'iode, un groupe nitro, ou un groupe cyano.

3. Vernis de transport de charges selon la revendication 2, dans lequel le composé triarylamine est un dérivé de triphénylamine représenté par la formule (7) : 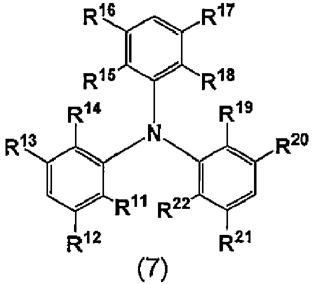
dans laquelle chacun de R¹¹ à R²² représente indépendamment un atome d'hydrogène, un atome d'halogène, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁵,
où Z⁵ est tel que défini dans la revendication 2.

4. Vernis de transport de charges selon la revendication 2, dans lequel le composé N,N,N',N'-tétraarylbenzidine représenté par la formule (2) est représenté par la formule (8) : 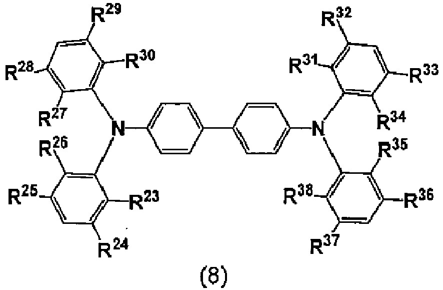
dans laquelle chacun de R²³ à R³⁸ représente indépendamment un atome d'hydrogène, un atome d'halogène, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁵,
où Z⁵ est tel que défini dans la revendication 2.

5. Vernis de transport de charges selon la revendication 2, dans lequel le composé N,N,N',N'-tétraarylbenzidine représenté par la formule (3) est représenté par la formule (9-1) : 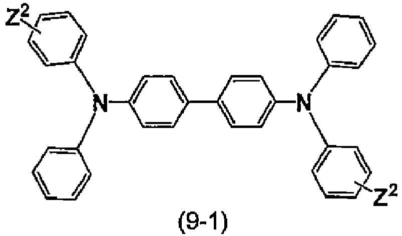 dans laquelle Z² est tel que défini dans la revendication 2.

6. Vernis de transport de charges selon la revendication 5, dans lequel le composé N,N,N',N'-tétraarylbenzidine représenté par la formule (3) est représenté par la formule (9-2) : 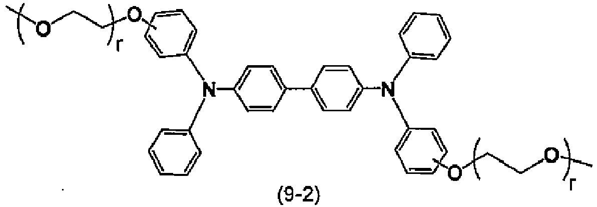 dans laquelle chacune des lettres r représente un entier de 1 à 10.

7. Vernis de transport de charges selon la revendication 6, dans lequel le composé N,N,N',N'-tétraarylbenzidine représenté par la formule (3) est représenté par l'une quelconque des formules (10-1) à (10-8) :

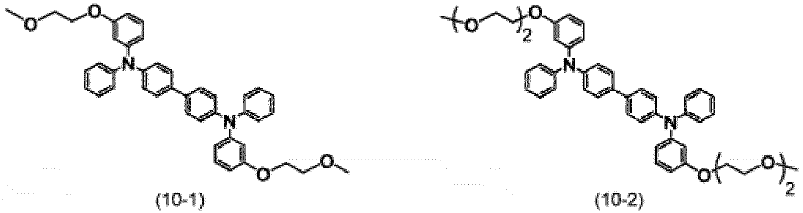

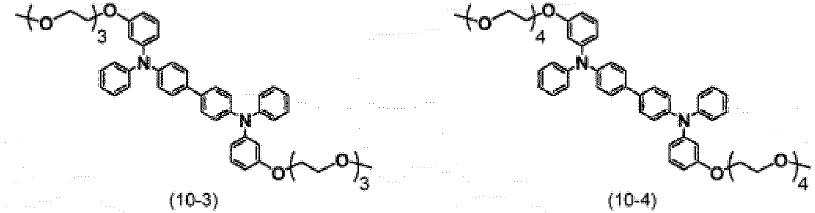

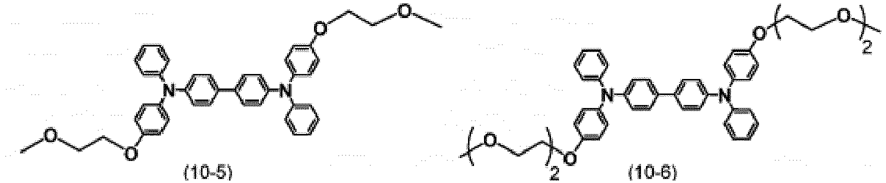

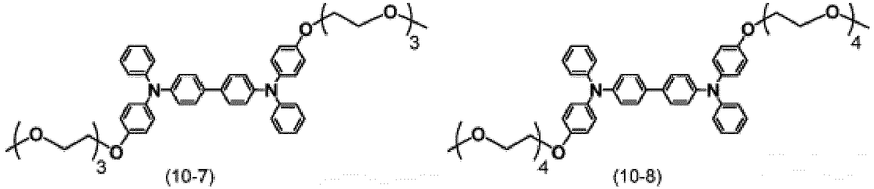

8. Vernis de transport de charges selon la revendication 7, dans lequel le composé N,N,N',N'-tétraarylbenzidine représenté par la formule (3) est représenté par la formule (10-7).

9. Vernis de transport de charges selon l'une quelconque des revendications 2 à 8, dans lequel le composé arylaldéhyde est représenté par la formule (11) ou la formule (12) : 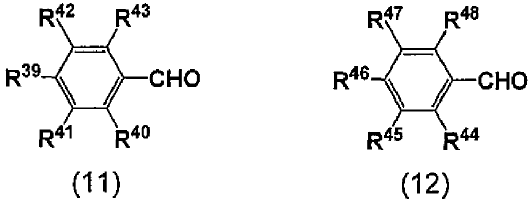
formules dans lesquelles R³⁹ représente un atome de fluor ou un groupe fluoroalkyle ayant 1 à 20 atomes de carbone,
chacun de R⁴⁰ à R⁴³ représente indépendamment un atome d'hydrogène, un groupe nitro, un groupe cyano, ou un groupe alkyle qui a 1 à 20 atomes de carbone et qui peut être substitué par un groupe nitro ou un groupe cyano, et
chacun de R⁴⁴ à R⁴⁸ représente indépendamment un atome de fluor ou un groupe fluoroalkyle ayant 1 à 20 atomes de carbone.

10. Vernis de transport de charges selon l'une quelconque des revendications 1 à 9, dans lequel le composé oligoaniline est représenté par la formule (13) : 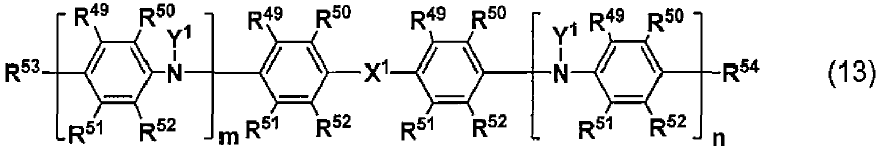
dans laquelle chacun de R⁴⁹ à R⁵⁴ représente indépendamment un atome d'hydrogène, un atome d'halogène (à l'exclusion d'un atome de fluor), un groupe nitro, un groupe cyano, un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁷, un groupe aryle ayant 6 à 20 atomes de carbone ou un groupe hétéroaryle ayant 2 à 20 atomes de carbone qui peut être substitué par Z⁸, ou un groupe -NHY², -NY³Y⁴, -C(O)Y⁵, -OY⁶, -SY⁷, -SO₃Y⁸, -C(O)OY⁹, -OC(O)Y¹⁰, -C(O)NHY¹¹, ou -C(O)NY¹²Y¹³,
chacun de Y² à Y¹³ représente indépendamment un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁷, ou un groupe aryle ayant 6 à 20 atomes de carbone ou un groupe hétéroaryle ayant 2 à 20 atomes de carbone qui peut être substitué par Z⁸,
X¹ représente -NY¹-, -O-, -S-, -(CR⁵⁵R⁵⁶)ₗ- ou une liaison simple, où R⁵⁵ et R⁵⁶ ont la même signification que R⁴⁹,
la lettre l est un entier de 1 à 20,
chaque Y¹ représente indépendamment un atome d'hydrogène, un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁷, ou un groupe aryle ayant 6 à 20 atomes de carbone ou un groupe hétéroaryle ayant 2 à 20 atomes de carbone qui peut être substitué par Z⁸,
Z⁷ représente un atome d'halogène (à l'exclusion d'un atome de fluor), un groupe nitro, un groupe cyano, ou un groupe aryle ayant 6 à 20 atomes de carbone ou un groupe hétéroaryle ayant 2 à 20 atomes de carbone qui peut être substitué par Z⁹,
Z⁸ représente un atome d'halogène (à l'exclusion d'un atome de fluor), un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁹,
Z⁹ représente un atome d'halogène (à l'exclusion d'un atome de fluor), un groupe nitro ou un groupe cyano, et
chacune des lettres m et n est indépendamment un entier de 1 à 10, et elles satisfont à m+n ≤ 10.

11. Vernis de transport de charges selon l'une quelconque des revendications 1 à 10, dans lequel l'hétéropolyacide est l'acide phosphotungstique.

12. Film mince de transport de charges pouvant être obtenu par l'utilisation du vernis de transport de charges selon l'une quelconque des revendications 1 à 11.

13. Elément électroluminescent organique comprenant le film mince de transport de charges selon la revendication 12.

14. Elément électroluminescent organique comprenant au moins une anode, une cathode, une couche luminescente, et le film mince de transport de charges selon la revendication 12,
dans lequel le film mince de transport de charges est disposé entre et en contact avec l'anode et la couche luminescente.

15. Procédé de production d'un film mince de transport de charges, **caractérisé par** l'application du vernis de transport de charges selon l'une quelconque des revendications 1 à 11 sur un substrat, et l'évaporation du solvant.

16. Procédé de production d'un élément électroluminescent organique, dans lequel le film mince de transport de charges selon la revendication 12 est utilisé.

17. Polymère qui a une masse moléculaire moyenne en masse, mesurée par chromatographie d'exclusion diffusion, de 500 à 200 000, et qui peut être obtenu par condensation : d'au moins un composé choisi parmi les composés triarylamines représentés par la formule (1) et les composés N,N,N',N'-tétraarylbenzidines représentés par la formule (2) ; et d'un composé N,N,N',N'-tétraarylbenzidine représenté par la formule (3) ; d'un composé arylaldéhyde fluoré représenté par la formule (4) ; et d'un dérivé de fluorène ayant un groupe carbonyle qui est représenté par la formule (5) ou la formule (6) ; 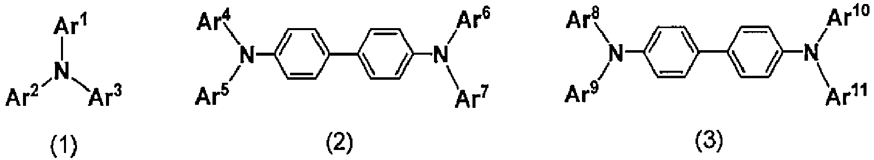 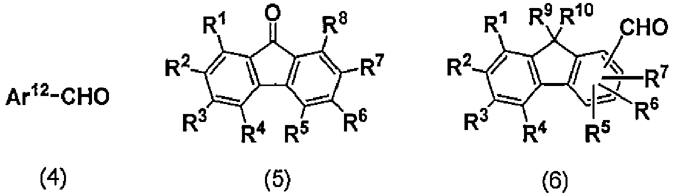
formules dans lesquelles chacun de Ar¹ à Ar⁷ représente indépendamment un groupe aryle qui a 6 à 20 atomes de carbone et qui peut être substitué par Z¹, sous réserve qu'au moins l'un des atomes de carbone formant un cycle dans chacun de Ar¹ à Ar³ soit non substitué, et qu'au moins l'un des atomes de carbone formant un cycle dans chacun de Ar⁴ à Ar⁷ soit non substitué,
chacun de Ar⁸ à Ar¹¹ représente indépendamment un groupe aryle qui a 6 à 20 atomes de carbone et qui peut être substitué par Z², sous réserve qu'au moins l'un des atomes de carbone formant un cycle dans au moins deux parmi Ar⁸ à Ar¹¹ soit non substitué, et qu'au moins l'un parmi Ar⁸ à Ar¹¹ soit substitué par Z²,
Ar¹² représente un groupe aryle qui a 6 à 20 atomes de carbone et qui est substitué par au moins un Z³ et qui peut être substitué par Z⁴,
chacun de R¹ à R⁸ représente indépendamment un atome d'hydrogène, un atome d'halogène, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁵,
chacun de R⁹ et R¹⁰ représente indépendamment un atome d'hydrogène, un groupe alkyle ayant 1 à 20 atomes de carbone, un groupe (poly)oxyde d'éthylène ayant 2 à 20 atomes de carbone, un groupe alcényle ayant 2 à 20 atomes de carbone ou un groupe alcynyle ayant 2 à 20 atomes de carbone qui peut être substitué par Z⁵, ou un groupe alkyle qui a 1 à 20 atomes de carbone et qui est substitué par un groupe éthényle ou un groupe éthynyle et qui peut être substitué par Z⁵,
Z¹ représente un atome d'halogène, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁵,
Z² représente un groupe alcoxy qui a 1 à 20 atomes de carbone et qui peut contenir une liaison éther,
Z³ représente un atome de fluor, un groupe fluoroalkyle ayant 1 à 20 atomes de carbone ou un groupe fluoroaryle ayant 6 à 20 atomes de carbone,
Z⁴ représente un atome de chlore, un atome de brome, un atome d'iode, un groupe nitro, un groupe cyano, ou un groupe alkyle ayant 1 à 20 atomes de carbone, un groupe alcényle ayant 2 à 20 atomes de carbone ou un groupe alcynyle ayant 2 à 20 atomes de carbone qui peut être substitué par Z⁶,
Z⁵ représente un atome d'halogène, un groupe nitro ou un groupe cyano, et
Z⁶ représente un atome de chlore, un atome de brome, un atome d'iode, un groupe nitro, ou un groupe cyano.
